# EUROPEAN PATENT APPLICATION

(11) **EP 4 766 031 A1**
(43) Date of publication of application: **24.06.2026**
(21) Application number: 24944464.7
(22) Date of filing: 24.12.2024
(51) Int. Cl.: H05K 1/02, H04M 1/02

(54) **FLEXIBLE CIRCUIT BOARD AND ELECTRONIC DEVICE**

(30) Priority: 29.06.2024 CN 202410875170
(71) Applicant: HUAWEI TECHNOLOGIES CO., LTD., Shenzhen 518129 (CN)
(72) Inventor: WANG, Qiyuan, Shenzhen, Guangdong 518129 (CN); SHENG, Wenju, Shenzhen, Guangdong 518129 (CN); LI, Quanli, Shenzhen, Guangdong 518129 (CN); LUO, Yanbiao, Shenzhen, Guangdong 518129 (CN); LONG, Teng, Shenzhen, Guangdong 518129 (CN); ZHANG, Feng, Shenzhen, Guangdong 518129 (CN)
(74) Representative: Isarpatent
(86) International application number: PCT/CN2024/141969
(87) International publication number: WO 2026/000900

(57) **Abstract**

Embodiments of this application relate to the field of signal transmission technologies, and provide a flexible circuit board and an electronic device, to reduce a large signal loss of an FPC caused by electromagnetic shielding. The flexible circuit board may have a first area and a second area. A reference layer of the flexible circuit board is located in the first area, and the reference layer and a signal layer are stacked. A first shielding layer is located in the first area, and the first shielding layer is stacked on a side that is of the signal layer and that faces away from the reference layer. A second shielding layer is located in the second area, and the second shielding layer and the signal layer are stacked. A first ground trace is electrically connected to the first shielding layer and the reference layer. The first ground trace is further electrically connected to the second shielding layer. A return signal of a signal transmitted via a signal trace in the signal layer may flow from the second shielding layer located in the second area, through the first ground trace, to the first shielding layer and the reference layer located in the first area.

## Description

This application claims the priority to Chinese Patent Application No. 202410875170.8, filed with the China National Intellectual Property Administration on June 29, 2024, and entitled "FLEXIBLE CIRCUIT BOARD AND ELECTRONIC DEVICE", which is incorporated herein by reference in its entirety.

### TECHNICAL FIELD

This application relates to the field of signal transmission technologies, and in particular, to a flexible circuit board and an electronic device.

### BACKGROUND

With continuous development of electronic products, a flexible circuit board (flexible printed circuit board, FPC) is widely used in consumer electronic products that have bending, flexing, and ultra-thin requirements, for example, electronic devices such as a foldable mobile phone, a foldable tablet, or a notebook computer, due to advantages such as being bendable and occupying small space. In addition, the FPC needs to have performance of resisting repetitive dynamic flexing. In addition, as integration of electronic devices continues to increase, effective electromagnetic shielding needs to be performed on signals, for example, high-speed signals, transmitted via FPCs. However, the electromagnetic shielding may generate a large signal loss, especially a signal loss of a dynamic flexing part of the FPC is more significant, thereby reducing a margin of signal quality.

### SUMMARY

This application provides a flexible circuit board and an electronic device, to reduce a large signal loss of an FPC caused by electromagnetic shielding.

To achieve the foregoing objective, this application uses the following technical solutions.

One aspect of this application provides a flexible circuit board. The flexible circuit board may have a first area and a second area. The flexible circuit board includes a signal layer, a reference layer, a first shielding layer, and a second shielding layer. The signal layer is located in the first area and the second area, and the signal layer includes a first ground trace. The reference layer is located in the first area, and the reference layer and the signal layer are stacked. A first shielding layer is located in the first area, and the first shielding layer is stacked on a side that is of the signal layer and that faces away from the reference layer. The second shielding layer is located in the second area. A first end of the first ground trace is located in the first area, and is electrically connected to the first shielding layer and the reference layer. A second end of the first ground trace is located in the second area, and is electrically connected to the second shielding layer.

In conclusion, the powder reference layer is located in the first area, and the reference layer is not disposed in the second area. Therefore, a quantity of film layers in the second area of the flexible circuit board may be less than a quantity of film layers in the first area. Therefore, a thickness of the second area may be less than a thickness of the first area. Based on this, when the flexible circuit board is used in a foldable electronic device, the second area of the flexible circuit board may be used as an area, subject to dynamic flexing, of the flexible circuit board, so that the flexible circuit board has good flexing resistance performance. In addition, a part that is of the signal layer and that is located in the first area may be covered by the first shielding layer, so that electromagnetic shielding can be performed on a signal in the first area by using the first shielding layer. In addition, a part of the signal layer that is located in the second area may be covered by the second shielding layer, so that electromagnetic shielding can be performed on a signal in the second area by using the second shielding layer. Based on this, because the second end that is of the first ground trace in the signal layer and that is located in the second area is electrically connected to the second shielding layer, the first end that is of the first ground trace and that is located in the first area is electrically connected to the first shielding layer and the reference layer. Therefore, a return signal of a signal transmitted via a signal trace in the signal layer may flow from the second shielding layer located in the second area to the first shielding layer and the reference layer located in the first area through the first ground trace, so that return paths of the second area and the first area in the flexible circuit board are continuous. In this way, impedance fluctuation of the flexible circuit board can be reduced, thereby reducing a signal (especially a high-frequency signal) loss caused by the second shielding layer and the first shielding layer.

In an optional implementation, the flexible circuit board further includes a second dielectric layer, a first electrically conductive adhesive, and a second electrically conductive adhesive. The second dielectric layer is located between the first shielding layer and the signal layer, and the second dielectric layer is further located between the second shielding layer and the signal layer. The second dielectric layer is provided with a first hole and a second hole. The first hole exposes the first end of the first ground trace, and the second hole exposes the second end of the first ground trace. In addition, the first electrically conductive adhesive is located in the first hole, and the first electrically conductive adhesive is connected to the first end of the first ground trace and the first shielding layer. The second electrically conductive adhesive is located in the second hole, and the second electrically conductive adhesive is connected to the second end of the first ground trace and the second shielding layer. In this case, the second shielding layer located in the second area may be electrically connected to the second end of the first ground trace in the signal layer through the second electrically conductive adhesive. The first end of the first ground trace is electrically connected to the first shielding layer through the first electrically conductive adhesive. In this way, the second shielding layer may be electrically connected to the first shielding layer through the first ground trace, the first electrically conductive adhesive, and the second electrically conductive adhesive.

In an optional implementation, the flexible circuit board further includes a third dielectric layer and a via. The third dielectric layer is located between the signal layer and the reference layer. The via penetrates the third dielectric layer, and two ends of the via are electrically connected to the first end of the first ground trace and the reference layer respectively. In this case, the first ground trace in the signal layer may be electrically connected to the reference layer through the via. Because the first shielding layer is electrically connected to the first ground trace, the first shielding layer may be electrically connected to the reference layer through the first ground trace and the via.

In an optional implementation, the flexible circuit board includes two second shielding layers: a second upper shielding layer and a second lower shielding layer. The signal layer is located between the second upper shielding layer and the second lower shielding layer. In this way, the signal layer is located in a part of the second area, and the second upper shielding layer and the second lower shielding layer are respectively covered above and below the signal layer, thereby improving an electromagnetic shielding effect.

In an optional implementation, a first gap H1 exists between the first shielding layer and the second shielding layer, and 0.2 mm≤H1≤6 mm. In this case, when H1<0.2 mm, a size of the first gap H1 is small, and a requirement for a mounting tolerance of attaching the first shielding layer and the second shielding layer to the second dielectric layer is high. Alternatively, when H1>6 mm, a size of the first gap H1 is excessively large, so that a signal line in the signal layer has a large area, in which electromagnetic shielding is not performed, at a position corresponding to the first gap H1. This reduces a signal shielding effect. Therefore, when 0.2 mm≤H1≤6 mm, it facilitates a side-by-side attachment of the first shielding layer and the second shielding layer to the second dielectric layer in an extension direction of the flexible circuit board, so that an electromagnetic shielding effect meets a design requirement.

In an optional implementation, the signal layer further includes a first signal trace, a second signal trace, and a second ground trace. The second signal trace and the first signal trace are spaced. The first signal trace and the second signal trace are located between the first ground trace and the second ground trace. A first end of the second ground trace is located in the first area, and is electrically connected to the first shielding layer and the reference layer. A second end of the second ground trace is located in the second area, and is electrically connected to the second shielding layer. In this case, the first signal trace and the second signal trace may be used to transmit a differential signal. In addition, when the first signal trace and the second signal trace transmit the differential signal, the return signal of the first signal trace may flow from the second shielding layer through the first ground trace that is close to the first signal trace, and then into the first shielding layer and the reference layer. Similarly, a return signal of the second signal trace may flow from the second shielding layer through the second ground trace close to the second signal trace, and then into the first shielding layer and the reference layer. Because the first ground trace and the second ground trace are spaced by the first signal trace and the second signal trace, noise coupling between the first ground trace and the second ground trace can be reduced.

In an optional implementation, the first signal trace includes a first part, a second part, and a third part, the first shielding layer covers the first part, and the second shielding layer covers the third part. The second part is located in the first gap H1. The first part has a first trace width L1, the second part has a second trace width L2, and the third part has a third trace width L3, where L2>L1 and L2>L3. Because the second part is located in the first gap H1, no electromagnetic shielding layer is disposed at a position of the second part. A trace width of the second part is increased to the second trace width, to enable the second trace width to be greater than the first trace width L1 of the first part and the third trace width L3 of the third part, so that the second part can more easily use the first signal trace on one side of the second part as a reference ground. In this way, impedance fluctuation of each part in the entire first signal trace can be reduced, thereby achieving an objective of reducing a signal loss caused by electromagnetic shielding.

In an optional implementation, a material of the first shielding layer is the same as a material of the signal layer, so that a manufacturing process of the flexible circuit board can be simplified.

In an optional implementation, an electrical conductivity of the first shielding layer may be greater than an electrical conductivity of the second shielding layer. Based on this, to enable the electrical conductivity of the first shielding layer to be greater than the electrical conductivity of the second shielding layer, for example, both the first shielding layer and the second shielding layer may be metal layers. The first shielding layer may be a metal layer with a large thickness, and the second shielding layer may be a metal layer with a small thickness, for example, a metal foil. In this case, an electromagnetic shielding effect of the first shielding layer may be greater than an electromagnetic shielding effect of the second shielding layer. In addition, because the second shielding layer has a small thickness, and the second shielding layer is located in the second area, when the second area of the flexible circuit board is used as an area subject to dynamic flexing, flexibility of the dynamic flexing area can be more easily improved. Alternatively, to enable the electrical conductivity of the first shielding layer to be greater than the electrical conductivity of the second shielding layer, for another example, the first shielding layer may be a metal layer, and the second shielding layer may be a dielectric layer doped with a metal particle (or a conductive powder). The conductive powder may be a metal powder or a powder made of a non-metal conductive material. In this case, the second shielding layer has higher flexibility and flexing resistance performance in comparison with the first shielding layer formed by a metal thin film, so that the second area having the second shielding layer in the flexible circuit board may be used as an area, subject to dynamic flexing, of the flexible circuit board.

Another aspect of this application provides an electronic device. The electronic device may include the foregoing circuit board and any one of the foregoing flexible circuit boards, and the flexible circuit board may be electrically connected to the circuit board. The electronic device has same technical effect as the flexible circuit board provided in the foregoing embodiment. Details are not described herein again.

In an optional implementation, the electronic device may include two circuit boards: a first circuit board and a second circuit board. In addition, the electronic device may further include a first housing and a second housing that are rotatably connected. The flexible circuit board includes two first areas, and a second area of the flexible circuit board is located between the two first areas. The first circuit board is disposed on the first housing, to be connected to the first housing. In addition, the first circuit board may be electrically connected to one of the two first areas. For example, the first circuit board may be electrically connected to one of the two first areas through a board-to-board connector, so that a position of the first area electrically connected to the first circuit board and a position of the first housing may be relatively fixed. The second circuit board is disposed on the second housing, to be connected to the second housing. In addition, the second circuit board may be electrically connected to the other of the two first areas. For example, the second circuit board may be electrically connected to the other of the two first areas through a board-to-board connector, so that a position of the first area electrically connected to the second circuit board and a position of the second housing may be relatively fixed. In this way, when the first housing and the second housing rotate, the two first areas are not subject to dynamic flexing, so that reliability of electrical connections between the flexible circuit board and the first circuit board and between the flexible circuit board and the second circuit board can be ensured.

In an optional implementation, the electronic device further includes a hinge mechanism that is located between the first housing and the second housing, and the first housing and the second housing are rotatably connected to the hinge mechanism. A part of the flexible circuit board located in the second area passes through the hinge mechanism. A part of the flexible circuit board that passes through the hinge mechanism may be used as a dynamic flexing area of the flexible circuit board.

Another aspect of this application provides an electronic device. The electronic device includes a first housing, a second housing, a first circuit board, a second circuit board, and a hinge mechanism. The first circuit board is connected to the first housing, and the second circuit board is connected to the second housing. The hinge mechanism is located between the first housing and the second housing, and the first housing and the second housing are rotatably connected to the hinge mechanism. The hinge mechanism includes a first metal hinge cover. The flexible circuit board has a third area, a fourth area, and a fifth area, and the third area is located between the fourth area and the fifth area. The fourth area is connected to the first housing, and the fifth area is connected to the second housing. The flexible circuit board includes a signal layer, a reference layer, and a third shielding layer. For example, the third shielding layer may be a metal layer with a high electrical conductivity and a large thickness. Alternatively, for another example, the third shielding layer may be a metal foil with a low electrical conductivity and a small thickness, or the third shielding layer may be a composite structure of a conductive powder or a metal particle and a dielectric material. The signal layer is located in the third area, the fourth area, and the fifth area. The reference layer is located in the fourth area and the fifth area, and is stacked with the signal layer. The third shielding layer is located in the fourth area and the fifth area, and is stacked on a side that is of the signal layer and that faces away from the reference layer. The first circuit board is electrically connected to the fourth area, and the second circuit board is electrically connected to the fifth area. The first metal hinge cover covers a part that is of the flexible circuit board and that is located at least in the third area. The first metal hinge cover is electrically connected to the reference layer. In conclusion, the third shielding layer covers both a part that is of the signal layer and that is located in the fourth area and a part that is of the signal layer and that is located in the fifth area. The third shielding layer located in the fourth area may perform electromagnetic shielding on a signal trace that is in the signal layer and that is located in the fourth area. Similarly, the third shielding layer located in the fifth area may perform electromagnetic shielding on a signal trace that is in the signal layer and that is located in the fifth area. In addition, the first metal hinge cover covers a part of the signal layer that is located in the third area. In addition, the first metal hinge cover may be electrically connected to the reference layer, so that the first metal hinge cover is grounded to the reference layer. In this case, the first metal hinge cover may perform electromagnetic shielding on the signal trace that is in the signal layer and that is located in the third area, so that the first metal hinge cover in the electronic device may be used to perform electromagnetic shielding on the third area of the flexible circuit board. In addition, electromagnetic shielding can be implemented in the third area, the fourth area, and the fifth area of the flexible circuit board. Based on this, because the first metal hinge cover may perform electromagnetic shielding on the signal trace that is in the signal layer and that is located in the third area, the electromagnetic shielding layer does not need to be disposed in the part that is in the flexible circuit board and that is located in the third area. In this way, because the first housing and the second housing are rotatably connected to the hinge mechanism, the part that is of the flexible circuit board and that is located in the third area may be used as an area, subject to dynamic flexing, of the flexible circuit board. In this case, because the shielding layer does not need to be disposed in the part that is of the flexible circuit board and that is located in the third area, a thickness of the flexible circuit board in the third area can be reduced, and flexing resistance of the flexible circuit board in the third area can be improved. In addition, the electromagnetic shielding layer does not need to be disposed in the part that is of the flexible circuit board and that is located in the third area, so that a signal loss caused by the electromagnetic shielding can be further reduced, thereby alleviating a problem of a conflict between the electromagnetic shielding and the signal loss.

In an optional implementation, the signal layer further includes a third signal trace, the third signal trace includes a fourth part and a fifth part, the third shielding layer covers the fourth part, and the fifth part passes through an accommodating cavity. The fourth part has a fourth trace width L4, and the fifth part has a fifth trace width L5, where L5>L4. It can be learned from the foregoing that the first metal hinge cover covers the fifth part of the third signal trace, and the electromagnetic shielding layer is not disposed in the third area covered by the first metal hinge cover in the flexible circuit board. Therefore, a trace width of the fifth part is increased to the fifth trace width L5, to enable the fifth trace width L5 to be greater than the fourth trace width L4 of the fourth part, so that the fifth part can more easily use the third signal trace on one side of the fifth part as a reference ground. In this way, impedance fluctuation of each part in the entire third signal trace can be reduced, and thereby achieving an objective of reducing a signal loss caused by electromagnetic shielding.

In an optional implementation, the third ground trace is electrically connected to the reference layer and the third shielding layer. The first metal hinge cover is further electrically connected to the third ground trace. In this way, the first metal hinge cover may be grounded to the reference layer through the third ground trace.

In an optional implementation, the first metal hinge cover is electrically connected to the third ground trace. The first metal hinge cover includes a first hinge cover body, a first metal pressing plate, and a second metal pressing plate. The first metal pressing plate is located on a side that is of the first hinge cover body and that faces the first circuit board, and the first metal pressing plate is connected to the first hinge cover body and is electrically connected to the third ground trace. The second metal pressing plate is located on a side that is of the first hinge cover body and that faces the second circuit board, and the second metal pressing plate is connected to the first hinge cover body and is electrically connected to the third ground trace. The first hinge cover body may be a metal hinge cover. When the first hinge cover body is connected to the first metal pressing plate and the second metal pressing plate that are located on two sides of the first hinge cover body, the first hinge cover body, the first metal pressing plate, and the second metal pressing plate may be electrically connected to each other. In this case, when the first metal pressing plate and the second metal pressing plate are electrically connected to the third ground trace and the fourth ground trace, the entire first metal hinge cover may be electrically connected to the third ground trace. In this case, the first metal pressing plate and the second metal pressing plate may be separately prepared, and then the first metal pressing plate and the second metal pressing plate are assembled with the first hinge cover body, to obtain the first metal hinge cover without changing a preparation process of the first hinge cover body, so that a manufacturing process of the first metal hinge cover can be simplified.

In an optional implementation, the electronic device further includes a third electrically conductive adhesive and a fourth electrically conductive adhesive. The third electrically conductive adhesive is located between the first metal pressing plate and the third ground trace, and the third electrically conductive adhesive is connected to the first metal pressing plate and the third ground trace. The third electrically conductive adhesive may be connected to the first metal pressing plate and the third ground trace, so that the first metal pressing plate is electrically connected to the third ground trace through the third electrically conductive adhesive. The fourth electrically conductive adhesive is located between the second metal pressing plate and the third ground trace, and the fourth electrically conductive adhesive is connected to the second metal pressing plate and the third ground trace. Similarly, the fourth electrically conductive adhesive may be connected to the second metal pressing plate and the third ground trace, so that the second metal pressing plate is electrically connected to the third ground trace through the fourth electrically conductive adhesive.

In an optional implementation, the signal layer further includes a fourth signal trace and a fourth ground trace. The third signal trace and the fourth signal trace are spaced, and the third signal trace and the fourth signal trace are located between the third ground trace and the fourth ground trace. The fourth ground trace is electrically connected to the reference layer and the third shielding layer, and the first metal hinge cover is further electrically connected to the fourth ground trace. In this case, a signal channel formed by the third signal trace and the fourth signal trace may be used to transmit a differential signal. In addition, the first metal hinge cover may be electrically connected to both the third ground trace and the fourth ground trace, so that an electromagnetic shielding effect of the third shielding layer can be improved.

In an optional implementation, the flexible circuit board further has a sixth area and a seventh area. The sixth area is located between the third area and the fourth area, the seventh area is located between the third area and the fifth area, and the signal layer is further located between the sixth area and the seventh area. The flexible circuit board further includes a fourth shielding layer and a fifth shielding layer. The fourth shielding layer is located in the sixth area, and the fourth shielding layer and the signal layer are stacked. The fifth shielding layer is located in the seventh area, and the fifth shielding layer and the signal layer are stacked. In addition, the signal layer includes a fifth ground trace and a sixth ground trace. A first end of the fifth ground trace is located in the fourth area, and is electrically connected to the third shielding layer and the reference layer in the fourth area. A second end of the fifth ground trace is located in the sixth area, and is electrically connected to the fourth shielding layer. A first end of the sixth ground trace is located in the fifth area, and is electrically connected to the third shielding layer and the reference layer in the fifth area. A second end of the sixth ground trace is located in the seventh area, and is electrically connected to the fifth shielding layer. In this case, compared with the third shielding layer, the fourth shielding layer and the fifth shielding layer have better flexing resistance. In this case, when a distance between a board-to-board connector and the first metal hinge cover is long, parts that are in the flexible circuit board and that are located in the sixth area and the seventh area and a part that is covered by the first metal hinge cover may be used as dynamic flexing areas, so that flexing resistance performance of the entire flexible circuit board can be improved. In addition, a shielding effect of the fourth shielding layer and the fifth shielding layer, a manner of electrically connecting the third shielding layer, the reference layer, and the fourth shielding layer through the fifth ground trace, a manner of electrically connecting the third shielding layer, the reference layer, and the fifth shielding layer through the sixth ground trace, and a technical effect of reducing a signal loss of the flexible circuit board are the same as those described above. Details are not described herein again.

In an optional implementation, an electrical conductivity of the third shielding layer is greater than that of at least one of the fourth shielding layer or the fifth shielding layer. For example, to enable the electrical conductivity of the third shielding layer to be greater than that of the at least one of the fourth shielding layer or the fifth shielding layer, the third shielding layer may be a metal layer with a large thickness. The at least one of the fourth shielding layer or the fifth shielding layer may be a metal foil with a small thickness, or the at least one of the fourth shielding layer or the fifth shielding layer may be a composite structure of a conductive powder or a metal particle and a dielectric material. A technical effect of the fourth shielding layer or the fifth shielding layer may be obtained in a similar way as a technical effect of the second shielding layer, and details are not described herein again.

In an optional implementation, the electrical conductivity of the third shielding layer is less than or equal to 5x10⁷ S/m. For example, the third shielding layer may be a metal foil with a small thickness, or the third shielding layer may be a composite structure of a conductive powder or a metal particle and a dielectric material.

In an optional implementation, the hinge mechanism further includes a second metal hinge cover, the second metal hinge cover is disposed opposite to the first metal hinge cover, and the second metal hinge cover is electrically connected to the reference layer. In this case, an accommodating cavity may be formed between the first metal hinge cover and the second metal hinge cover, and a part that is of the flexible circuit board and that is located in at least the third area can pass through the accommodating cavity. Because both the first metal hinge cover and the second metal hinge cover are electrically connected to the reference layer, the grounded first metal hinge cover and the grounded second metal hinge cover respectively cover above and below the third area of the flexible circuit board, so that an electromagnetic shielding effect can be improved.

### BRIEF DESCRIPTION OF DRAWINGS

FIG. 1 is a diagram of a structure of an electronic device according to an embodiment of this application;
FIG. 2 is a diagram of another structure of an electronic device according to an embodiment of this application;
FIG. 3 is a diagram of another structure of an electronic device according to an embodiment of this application;
FIG. 4 is a sectional view obtained by cutting along a dashed line A1-A2 in FIG. 2;
FIG. 5 is a diagram of a structure of the electronic device shown in FIG. 4 in a folded state;
FIG. 6 is a sectional view of a flexible circuit board obtained by cutting along a dashed line A3-A4 in FIG. 3;
FIG. 7 is a top view of a signal layer obtained in a B direction in FIG. 6;
FIG. 8 is a diagram of a structure of a second shielding layer in FIG. 6;
FIG. 9 is another sectional view of a flexible circuit board obtained by cutting along a dashed line A3-A4 in FIG. 3;
FIG. 10 is still another sectional view of a flexible circuit board obtained by cutting along a dashed line A3-A4 in FIG. 3;
FIG. 11 is another top view of a flexible circuit board obtained in a B direction in FIG. 6;
FIG. 12 is an exploded view of a structure of a flexible circuit board according to an embodiment of this application;
FIG. 13 is a sectional view obtained by cutting along a dashed line A5-A6 in FIG. 11;
FIG. 14 is a top view obtained in a C direction in FIG. 13;
FIG. 15 is another top view obtained in a C direction in FIG. 13;
FIG. 16 is a diagram of a structure of a first signal trace in FIG. 15;
FIG. 17 is a diagram of a structure of a flexible circuit board according to an embodiment of this application;
FIG. 18 is another sectional view obtained by cutting along a dashed line A3-A4 in FIG. 3;
FIG. 19 is a diagram of another structure of an electronic device according to an embodiment of this application;
FIG. 20 is a diagram of another structure of a flexible circuit board according to an embodiment of this application;
FIG. 21 is another sectional view obtained by cutting along a dashed line A1-A2 in FIG. 2;
FIG. 22 is a diagram of another structure of an electronic device according to an embodiment of this application;
FIG. 23 is a diagram of another structure of an electronic device according to an embodiment of this application;
FIG. 24 is a top view obtained in a D direction in FIG. 23;
FIG. 25 is a diagram of another structure of a flexible circuit board according to an embodiment of this application;
FIG. 26 is a diagram of another structure of an electronic device according to an embodiment of this application;
FIG. 27 is a sectional view obtained in an E direction in FIG. 26;
FIG. 28 is a diagram of another structure of an electronic device according to an embodiment of this application;
FIG. 29 is a top view obtained in an F direction in FIG. 28; and
FIG. 30 is another top view obtained in an F direction in FIG. 28.

Reference numerals:
01: electronic device; 10: display; 11: first housing; 12: second housing; 101: first circuit board; 102: second circuit board; 111: first electronic component; 112: second electronic component; 30: flexible circuit board; 301: first area; 302: second area; 31: signal layer; 32: reference layer; 33: first shielding layer; 34: second shielding layer; 42: second dielectric layer; 43: third dielectric layer; 300: signal channel; 311: first signal trace; 312: second signal trace; 41: third dielectric layer; 340: metal particle; 313: first ground trace; 314: second ground trace; 51: first electrically conductive adhesive; 52: second electrically conductive adhesive; 421: first hole; 422: second hole; 431: via; 3111: first part; 3112: second part; 3113: third part; 341: second upper shielding layer; 342: second lower shielding layer; 20: hinge mechanism; 201: first metal hinge cover; 202: second metal hinge cover; 1101: first rear housing; 1102: first middle frame; 1201: second rear housing; 1202: second middle frame; 3114: fourth part; 3115: fifth part; 315: third signal trace; 316: fourth signal trace; 317: third ground trace; 318: fourth ground trace; 303: third area; 304: fourth area; 305: fifth area; 2011: first hinge cover body; 2012: first metal pressing plate; 2013: second metal pressing plate; 53: third electrically conductive adhesive; 54: fourth electrically conductive adhesive; 50: third shielding layer; 344: fourth shielding layer; 345: fifth shielding layer; 306: sixth area; 307: seventh area; 319: fifth ground trace; and 320: sixth ground trace.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms "first" and "second" mentioned below are merely intended for a purpose of convenience of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In this application, unless otherwise expressly specified and limited, the term "connection" should be understood in a broad sense. For example, "connection" may be a fixed mechanical connection, or may be a detachable mechanical connection or an integral connection. Alternatively, "connection" may be a direct connection, or may be an indirect connection via an intermediate medium. In addition, "transmission connection" refers to a connection relationship that can implement mechanical transmission, for example, rotation and movement. The "transmission connection" includes but is not limited to a fixed mechanical connection, a detachable connection (for example, a snap-fit connection or a threaded connection), and abutting and meshing of surface contact.

In addition, unless otherwise expressly specified and limited, the term "electrical connection" should be understood in a broad sense. For example, an "electrical connection" may be a direct electrical connection, for example, two components are physically in contact and electrically connected; or may be understood as that in a line structure, different components are electrically connected through a physical line that can transmit an electrical signal, such as a printed circuit board (printed circuit board, PCB) copper foil or a conducting wire, to transmit an electrical signal. Alternatively, "electrical connection" may be an indirect electrical connection between two components via an intermediate medium. Alternatively, "electrical connection" may be an electrical connection between two components in a separated/non-contact manner. For example, two components are electrically connected in a capacitive coupling manner, to transmit an electrical signal.

A "communication connection" may indicate electrical signal transmission, and includes a wireless communication connection and a wired communication connection. The wireless communication connection does not require a physical medium and does not belong to a connection relationship that defines a construction of a product.

In embodiments of this application, "perpendicular" and "parallel" are described to respectively represent being roughly perpendicular and being roughly parallel within an allowed error range. The error range may be a range in which a deviation angle is less than or equal to 5°, 8°, or 10° relative to being absolutely perpendicular and being absolutely parallel. This is not specifically limited herein.

In embodiments of this application, orientation terms such as "upper", "lower", "left", and "right" may include but are not limited to definitions based on illustrated orientations in which components in the accompanying drawings are placed. It should be understood that, these directional terms may be relative concepts used for relative description and clarification, and may change accordingly depending on a change in the orientations in which the components are placed in the accompanying drawings. In the accompanying drawings of embodiments of this application, an assembly is represented by using a guide line with an arrow, and a component is represented by using only a guide line.

An embodiment of this application provides an electronic device. The electronic device may be used in various communication systems or communication protocols, for example, a Bluetooth (Bluetooth, BT) communication technology, a global positioning system (global positioning system, GPS) communication technology, a global system of mobile communication (global system of mobile communication, GSM) communication technology, a wireless fidelity (wireless fidelity, Wi-Fi) communication technology, a wideband code division multiple access (wideband code division multiple access wireless, WCDMA) communication technology, long term evolution (long term evolution, LTE), a 5G communication technology, and another future communication technology. The electronic device in embodiments of this application may be a mobile phone (mobile phone), a tablet computer (pad), a notebook computer, a smart home, a smart wearable device (for example, a smartwatch, a smart band, smart glasses, or a smart helmet), a virtual reality (virtual reality, VR) electronic device, an augmented reality (augmented reality, AR) electronic device, or the like. Alternatively, the electronic device may be a handheld device that has a wireless communication function, a computing device or another processing device connected to a wireless modem, a vehicle-mounted device, an electronic device in a 5G network, an electronic device in a future evolved public land mobile network (public land mobile network, PLMN), or the like. This is not limited in embodiments of this application.

In some embodiments, the electronic device may have a display function. In this case, the electronic device may include a display and a processor electrically connected to the display. The processor may provide display data for the display, to drive the display to display an image. For example, the processor may include one or more processing units. For example, the processor may include a system on chip (system on a chip, SoC), an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural network processing unit (neural-network processing unit, NPU), and/or the like. Different processing units may be independent components, or may be integrated into one or more processors.

In addition, the electronic device may further include an interface for external memory, an internal memory, a universal serial bus (universal serial bus, USB) interface, a charging management module, a power management module, a battery, an antenna, a mobile communication module, a wireless communication module, an audio module, a speaker, a receiver, a microphone, a headset jack, a sensor module, a button, a camera, and the like that are electrically connected to the processor. The sensor module may include a pressure sensor, a gyroscope sensor, a barometric pressure sensor, a magnetic sensor, an acceleration sensor, a distance sensor, an optical proximity sensor, a fingerprint sensor, a temperature sensor, a touch sensor, an ambient light sensor, a bone conduction sensor, and the like.

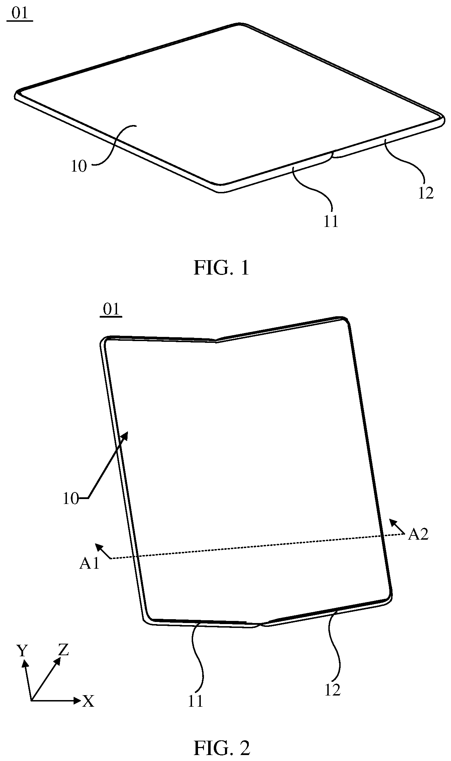

The electronic device is a foldable electronic device. For example, the foldable electronic device may be a foldable mobile phone, a foldable tablet computer, or a foldable notebook computer. For ease of description, an example in which the electronic device is a foldable tablet computer is used below for description. In this case, the electronic device 01 may include the display 10 shown in FIG. 1, and the display 10 may be a flexible display. In some embodiments of this application, the flexible display 10 may be a self-luminous display, for example, an organic light-emitting diode (organic light-emitting diode, OLED) display, a micro (micro or mini) light-emitting diode (light-emitting diode) display, a quantum dot light-emitting diode (quantum dot light-emitting diode, QLED) display, or the like. Alternatively, in some other embodiments of this application, the display 10 may be a liquid crystal display (liquid crystal display, LCD) that requires a backlight source. This is not limited in this application.

In addition, in a process of folding or unfolding the electronic device 01, to support the display 10, the electronic device 01 may further include at least two housings (for example, the at least two housings may be a first housing 11 and a second housing 12 respectively) disposed on a back of the display 10 (a surface disposed opposite to a display surface of the display 10). The first housing 11 and the second housing 12 may be rotatably connected.

An included angle between the first housing 11 and the second housing 12 when the electronic device 01 is in an unfolded state is not limited in this application. For example, the unfolded state of the electronic device 01 may mean that, as shown in FIG. 1, an included angle between two parts that are in the display 10 and that are respectively connected to the first housing 11 and the second housing 12 may be equal to or approximately equal to 180°. Alternatively, for another example, the unfolded state of the electronic device 01 may mean that, as shown in FIG. 2, a maximum included angle between two parts that are in the display 10 and that are respectively connected to the first housing 11 and the second housing 12 may be less than 180°.

To describe a position relationship between components in the electronic device 01 below, an XYZ coordinate system shown in FIG. 2 may be established. An X direction is a direction from the first housing 11 to the second housing 12, or a direction from the second housing 12 to the first housing 11. A Y direction is parallel to a rotation centers of the first housing 11 and the second housing 12. In addition, a Z direction is a stacking direction of the display and the first housing 11 (or the second housing 12).

In addition, the foregoing descriptions are provided by using an example in which the electronic device 01 has two housings (the first housing 11 and the second housing 12) that are rotatably connected. In this case, the electronic device 01 is a two-fold electronic device. In some other embodiments of this application, the electronic device 01 may alternatively be a multi-fold electronic device. In this case, the electronic device may have three or more housings, and two adjacent housings may be rotatably connected. For ease of description, the following uses an example in which the electronic device is the foregoing two-fold electronic device as an example for description.

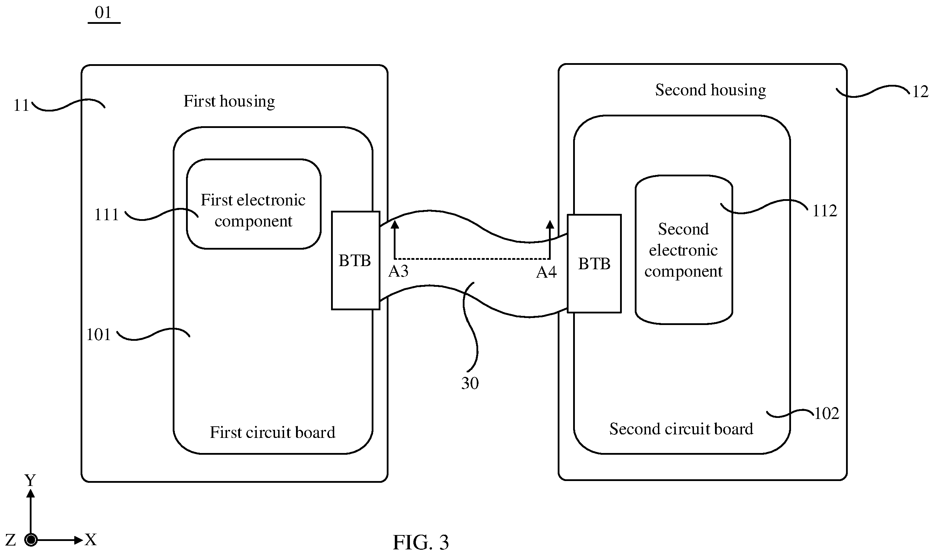

Based on this, as shown in FIG. 3, the electronic device 01 may further include a flexible circuit board 30, a first circuit board 101, and a second circuit board 102. In addition, the electronic device 01 may further include at least one first electronic component 111 and at least one second electronic component 112. The first circuit board 101 may be disposed on the first housing 11, and is connected to the first housing 11. The second circuit board 102 may be disposed on the second housing 12, and is connected to the second housing 12. Two ends of the flexible circuit board 30 may be electrically connected to the first circuit board 101 and the second circuit board 102 respectively. The first circuit board 101 and the second circuit board 102 may be PCBs.

For example, two ends of the flexible circuit board 30 may be electrically connected to the first circuit board 101 and the second circuit board 102 respectively through a board-to-board (board-to-board, BTB) connector, so that the first electronic component 111 disposed on the first circuit board 101 may be electrically connected to the second electronic component 112 on the second circuit board 102 through the flexible circuit board 30, and signal transmission between the first electronic component 111 and the second electronic component 112 can be implemented. A type of the first electronic component 111 or the second electronic component 112 is not limited in this application. For example, a high-speed signal may be transmitted between the first electronic component 111 and the second electronic component 112, for example, a high-speed signal such as a USB signal, a display port (display port, DP) signal, an embedded display port (embedded display port, eDP) signal, a mobile industry processor interface (mobile industry processor interface, MIPI) signal, and a radio frequency (radio frequency, RF) signal, so that signals related to an antenna, a camera, and a display can be transmitted across screens.

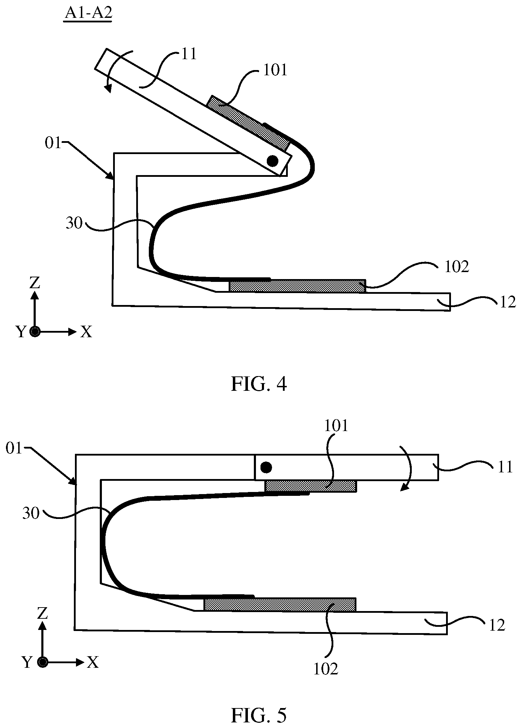

In some embodiments of this application, as shown in FIG. 4 (which is a sectional view obtained by cutting along a dashed line A1-A2 in FIG. 2), the first housing 11 may be rotatably connected to the second housing 12. The first circuit board 101 may be disposed on the first housing 11, and the second circuit board 102 may be disposed on the second housing 12. In this case, when the first housing 11 rotates counterclockwise in a direction indicated by an arc arrow, the included angle between the first housing 11 and the second housing 12 may be the maximum included angle. In this case, the electronic device 01 may be in an unfolded state. In addition, as shown in FIG. 5, when the first housing 11 rotates clockwise in a direction indicated by an arc arrow, the included angle between the first housing 11 and the second housing 12 decreases. In addition, when the included angle between the first housing 11 and the second housing 12 is approximately 0°, the electronic device 01 may be in a folded state.

It can be learned from FIG. 4 and FIG. 5 that, in a process in which the first housing 11 and the second housing 12 rotate relative to each other, a part of the flexible circuit board 30, for example, a part that is of the flexible circuit board 30 and that is located between the first circuit board 101 and the second circuit board 102, is subject to dynamic flexing. In the following example that describes a structure of the flexible circuit board 30, when a requirement of dynamic flexing performance for the flexible circuit board 30 is met, electromagnetic shielding on a signal trace in the flexible circuit board 30 can be performed, and a large signal loss of the flexible circuit board 30 caused by electromagnetic shielding can be reduced.

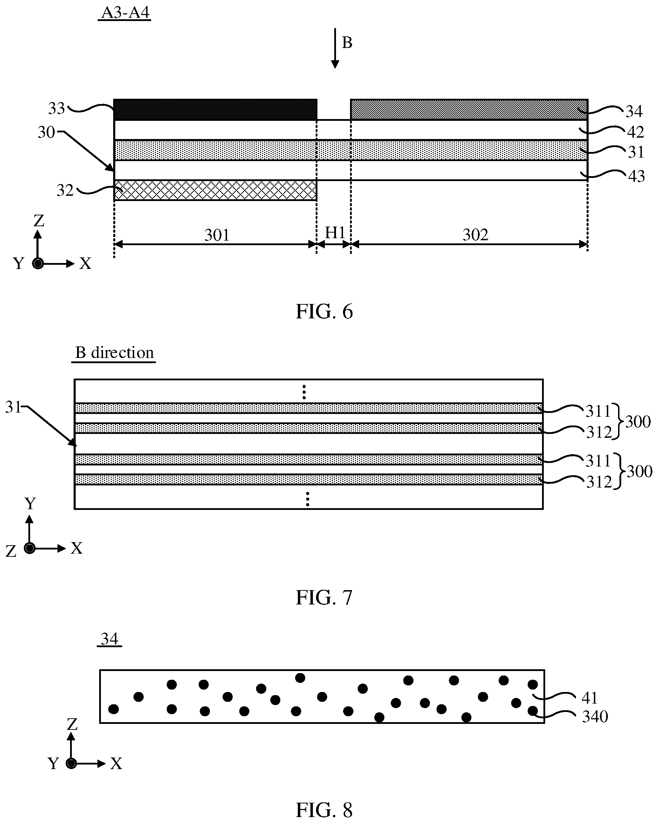

In some embodiments of this application, as shown in FIG. 6 (which is a sectional view of a flexible circuit board obtained by cutting along a dashed line A3-A4 in FIG. 3), the flexible circuit board 30 may have a second area 302 and at least one first area 301. FIG. 6 is an example for description by using an example in which the flexible circuit board 30 has one first area 301. In addition, the flexible circuit board 30 may include a signal layer 31, a reference layer 32, a first shielding layer 33, and a second shielding layer 34.

Based on this, still as shown in FIG. 6, the signal layer 31 may be located in the first area 301 and the second area 302. The signal layer 31 may include a signal trace for transmitting a signal (for example, the high-speed signal). For example, as shown in FIG. 7 (which is a top view of a signal layer obtained in a B direction in FIG. 6), the signal layer 31 may include at least one signal channel 300. When the signal channel 300 is configured to transmit a differential signal, the signal channel 300 may include two signal traces, for example, a first signal trace 311 and a second signal trace 312 that are spaced. Alternatively, for another example, when the signal channel 300 is configured to transmit a non-differential signal, the signal channel may include only one signal trace. A quantity of signal traces in the signal channel 300 is not limited in this application. For ease of description, the following uses an example in which the signal channel 300 includes the first signal trace 311 and the second signal trace 312 for description.

The trace in the signal layer 31 may be formed by performing patterning processing on a metal layer, for example, a same layer, by using a photolithography process. Still as shown in FIG. 6, the reference layer 32 may be located in the first area 301, and the reference layer 32 and the signal layer 31 may be stacked. The reference layer 32 may have a block-shaped ground metal pattern, and the reference layer 32 may provide a return path of a return signal for the signal trace in the signal layer 31.

To isolate the signal layer 31 from the reference layer 32, as shown in FIG. 6, the flexible circuit board 30 may further include a third dielectric layer 43 located between the signal layer 31 and the reference layer 32. The third dielectric layer 43 may be located in the first area 301 and the second area 302. The third dielectric layer 43 may be a polymer insulation material thin film having specific flexibility, for example, a polyimide film or a polyester film.

In addition, still as shown in FIG. 6, the first shielding layer 33 is located in the first area 301, and the first shielding layer 33 is stacked on a side that is of the signal layer 31 and that faces away from the reference layer 32. For example, the first shielding layer 33 may be a metal film layer with a large thickness, for example, a copper layer or a silver layer. The first shielding layer 33 may conduct electricity via free electrons inside the first shielding layer 33, to implement a shielding function against electromagnetic interference (electromagnetic interference, EMI).

In some embodiments of this application, a material of the first shielding layer 33 may be the same as a material of the signal layer 31, so that a manufacturing process of the flexible circuit board 30 can be simplified. For example, both the material of the first shielding layer 33 and the material of the signal layer 31 may be metal copper. In this case, in the traces (for example, the first signal trace 311 and the second signal trace 312 shown in FIG. 7) in the signal layer 31, a part located in the first area 301 may be covered by the first shielding layer 33, so that EMI shielding can be performed on a signal in the first area 301 by using the first shielding layer 33.

Based on this, still as shown in FIG. 6, the second shielding layer 34 may be located in the second area 302, and the second shielding layer 34 and the signal layer 31 may be stacked. FIG. 6 is an example in which the second shielding layer 34 and the first shielding layer 33 are located on a same side of the signal layer 31. In some other embodiments of this application, the second shielding layer 34 and the reference layer 32 may be located on a same side of the signal layer 31.

In addition, an electrical conductivity of the first shielding layer 33 may be greater than an electrical conductivity of the second shielding layer 34. For example, to enable the electrical conductivity of the first shielding layer 33 to be greater than the electrical conductivity of the second shielding layer 34, the second shielding layer 34 is a metal layer with a small thickness, for example, a metal foil. When the first shielding layer 33 is a metal layer, a thickness of the second shielding layer 34 may be less than a thickness of the first shielding layer 33. In this case, an electromagnetic shielding effect of the first shielding layer 33 may be greater than an electromagnetic shielding effect of the second shielding layer 34. In addition, because the second shielding layer 34 has a small thickness, and the second shielding layer 34 is located in the second area 302, the second area 302 of the flexible circuit board 30 may be used as an area, subject to dynamic flexing, of the flexible circuit board 30, to improve flexibility of the dynamic flexing area.

Alternatively, to enable the electrical conductivity of the first shielding layer 33 to be greater than the electrical conductivity of the second shielding layer 34, for another example, when the first shielding layer 33 is a metal film layer, the second shielding layer 34 may be a dielectric layer doped with metal particles (or conductive powder). In other words, the second shielding layer 34 may be a composite structure of a conductive powder or a metal particle and a dielectric material. For example, as shown in FIG. 8, the second shielding layer 34 may include a first dielectric layer 41 and a metal particle 340 (or a conductive powder) doped in the first dielectric layer 41. The conductive powder may be a metal powder or a powder made of a non-metal conductive material. A material of the metal particle 340 may include metal copper, metal silver, metal aluminum, or the like. The second shielding layer 34 may conduct electricity via a positive ion and a negative ion in the metal particle 340, to implement a shielding function against EMI. In this case, in the traces (for example, the first signal trace 311 and the second signal trace 312 shown in FIG. 7) in the signal layer 31, a part located in the second area 302 may be covered by the second shielding layer 34, so that EMI shielding can be performed on a signal in the second area 302 by using the second shielding layer 34.

In addition, because the second shielding layer 34 has the first dielectric layer 41, and metal particles 340 used for electrical conduction are dispersed in the first dielectric layer 41, the second shielding layer 34 has higher flexibility and flexing resistance performance than those of the first shielding layer 33 formed by the metal thin film. Therefore, when the flexible circuit board 30 is used in a foldable electronic device, the first area 301 that is in the flexible circuit board 30 and that has the second shielding layer 34 may be located in an area, subject to dynamic flexing, of the flexible circuit board, to ensure that the flexible circuit board 30 has good flexing resistance performance in a folding process of the electronic device, and reduce a probability that a function of the flexible circuit board 30 fails.

Still as shown in FIG. 6, to isolate the first shielding layer 33 from the signal layer 31, and isolate the second shielding layer 34 from the signal layer 31, the flexible circuit board 30 may further include a second dielectric layer 42. The second dielectric layer 42 may be located in the first area 301 and the second area 302. In addition, a part that is of the second dielectric layer 42 and that is located in the second area 302 may be located between the second shielding layer 34 and the signal layer 31. A part that is of the second dielectric layer 42 and that is located in the first area 301 may be located between the first shielding layer 33 and the signal layer 31. A material of the second dielectric layer 42 and a material of the first dielectric layer 41 may be the same as or different from a material of the third dielectric layer 43. This is not limited in this application.

In some embodiments of this application, a first gap H1 shown in FIG. 6 may exist between the first shielding layer 33 and the second shielding layer 34. For example, the first gap H1 may satisfy: 0.2 mm≤H1≤6 mm. In this case, when H1<0.2 mm, a size of the first gap H1 is small, and a requirement for a mounting tolerance of attaching the first shielding layer 33 and the second shielding layer 34 to the second dielectric layer 42 is high. Alternatively, when H1>6 mm, a size of the first gap H1 is excessively large, so that a signal line in the signal layer 31 has a large area, in which EMI shielding is not performed, at a position corresponding to the first gap H1. This reduces a signal shielding effect.

Therefore, when 0.2 mm≤H1≤6 mm, it facilitates a side-by-side attachment of the first shielding layer 33 and the second shielding layer 34 to the second dielectric layer 42 in an extension direction (that is, the X direction) of the flexible circuit board 30, so that an EMI shielding effect meets a design requirement. For example, H1 may be 0.2 mm, 0.3 mm, 0.5 mm, 0.8 mm, 1 mm, 3 mm, 5 mm, or 6 mm.

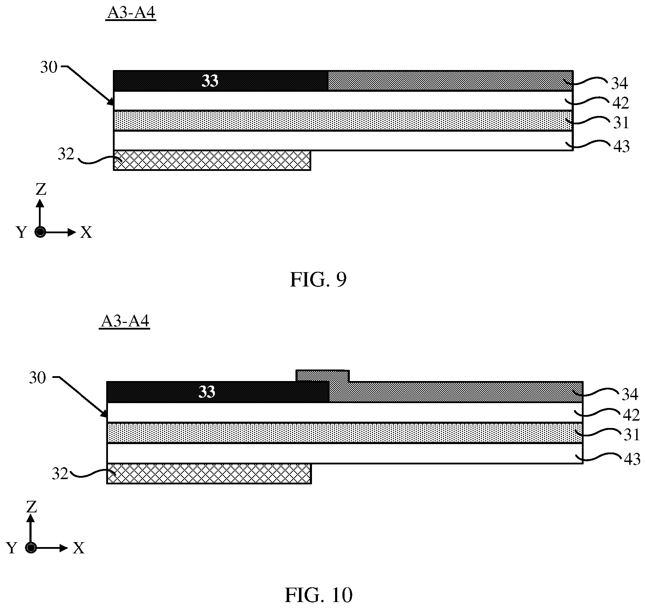

Alternatively, in some other embodiments of this application, as shown in FIG. 9 (which is another sectional view of a flexible circuit board obtained by cutting along a dashed line A3-A4 in FIG. 3), the first shielding layer 33 and the second shielding layer 34 may be spliced together in an extension direction (that is, the X direction) of the flexible circuit board 30. Alternatively, as shown in FIG. 10 (which is another sectional view of a flexible circuit board obtained by cutting along a dashed line A3-A4 in FIG. 3), a part of the first shielding layer 33 and a part of the second shielding layer 34 may be stacked in an extension direction (that is, the X direction) of the flexible circuit board 30. In FIG. 10, an example in which the second shielding layer 34 is stacked above the first shielding layer 33 is used for description. In some other embodiments, the first shielding layer 33 may be stacked above the second shielding layer 34.

A manner of disposing the first shielding layer 33 and the second shielding layer 34 in the extension direction (that is, the X direction) of the flexible circuit board 30 is not limited in this application. For ease of description, the following uses an example in which the first gap H1 exists between the first shielding layer 33 and the second shielding layer 34 shown in FIG. 9 for description.

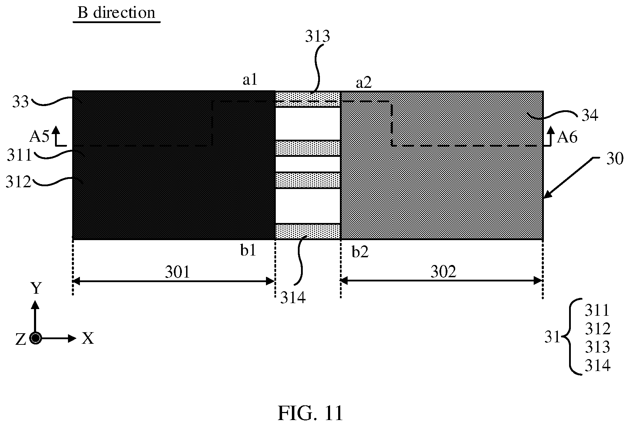

It can be learned from the foregoing that, as shown in FIG. 11 (which is another top view of the flexible circuit board obtained in a B direction in FIG. 6), the second shielding layer 34 used to implement EMI shielding is disposed in the second area 302 of the flexible circuit board 30, and the first shielding layer 33 used to implement EMI shielding is disposed in the first area 301 of the flexible circuit board 30. Based on this, to reduce a loss (for example, a loss of a high-speed signal) generated on signal traces (for example, the first signal trace 311 and the second signal trace 312) caused by the second shielding layer 34 and the first shielding layer 33, the signal layer 31 may further include at least one ground trace configured to electrically connect the second shielding layer 34 and the first shielding layer 33 and the reference layer 32. The following describes a manner of setting the ground trace by using an example.

For example, still as shown in FIG. 11, in a case in which the signal layer 31 has the first signal trace 311 and the second signal trace 312, the signal layer 31 may further include two ground traces configured to electrically connect the second shielding layer 34 and the first shielding layer 33, which are respectively a first ground trace 313 and a second ground trace 314. The first signal trace 311 and the second signal trace 312 may be located between the first ground trace 313 and the second ground trace 314. The first signal trace 311, the second signal trace 312, the first ground trace 313, and the second ground trace 314 may be formed by using a same metal layer by using a photolithography process.

An extension direction of the first signal trace 311 and the second signal trace 312 may be the same as the extension direction (that is, the X direction) of the flexible circuit board 30, and the first signal trace 311 and the second signal trace 312 may be located in the first area 301, the second area 302, and the gap (that is, the first gap H1) between the first area 301 and the second area 302.

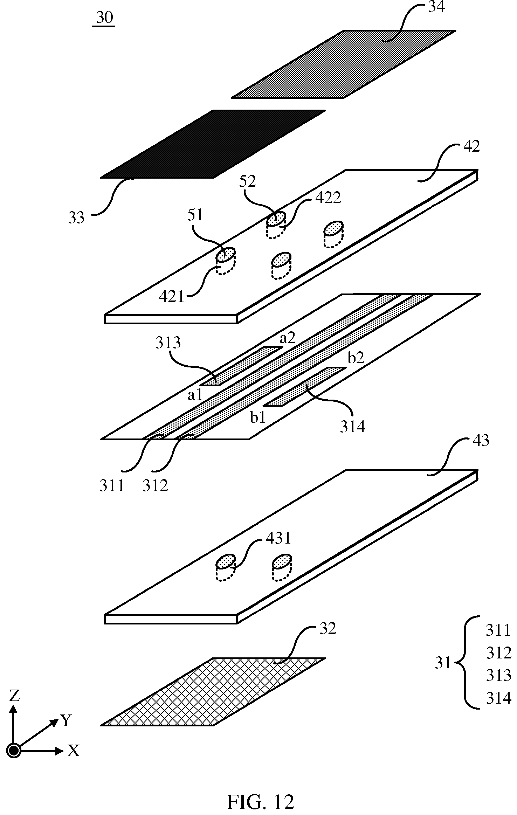

Based on this, still as shown in FIG. 11, a first end a1 of the first ground trace 313 may be located in the first area 301. In addition, the first end a1 of the first ground trace 313 may be electrically connected to the first shielding layer 33 and the reference layer 32 shown in FIG. 12. A second end a2 of the first ground trace 313 may be located in the second area 302. In addition, the second end a2 of the first ground trace 313 may be electrically connected to the second shielding layer 34.

In addition, a first end b1 of the second ground trace 314 may be located in the first area 301. In addition, the first end b1 of the second ground trace 314 may be electrically connected to the first shielding layer 33 and the reference layer 32 shown in FIG. 12. A second end b2 of the second ground trace 314 may be located in the second area 302. In addition, the second end b2 of the second ground trace 314 may be electrically connected to the second shielding layer 34. In this case, the second shielding layer 34 located in the second area 302 may be connected to the first shielding layer 33 and the reference layer 32 (as shown in FIG. 12) located in the first area 301 through the first ground trace 313 and the second ground trace 314.

The following uses the first ground trace 313 as an example to describe a manner in which the first ground trace 313 electrically connects the second shielding layer 34 and the first shielding layer 33 and the reference layer 32. In some embodiments of this application, as shown in FIG. 12 (which is an exploded view of a flexible circuit board), a first hole 421 and a second hole 422 may be provided on the second dielectric layer 42. The first hole 421 may expose the first end a1 of the first ground trace 313, and the second hole 422 may expose the second end a2 of the first ground trace 313.

In addition, as shown in FIG. 12, the flexible circuit board 30 may further include a first electrically conductive adhesive 51 and a second electrically conductive adhesive 52. The first electrically conductive adhesive 51 may be located in the first hole 421, and the first electrically conductive adhesive 51 may be connected to the first end a1 of the first ground trace 313 and the first shielding layer 33. The second electrically conductive adhesive 52 may be located in the second hole 422, and the second electrically conductive adhesive 52 may be connected to the second end a2 of the first ground trace 313 and the second shielding layer 34.

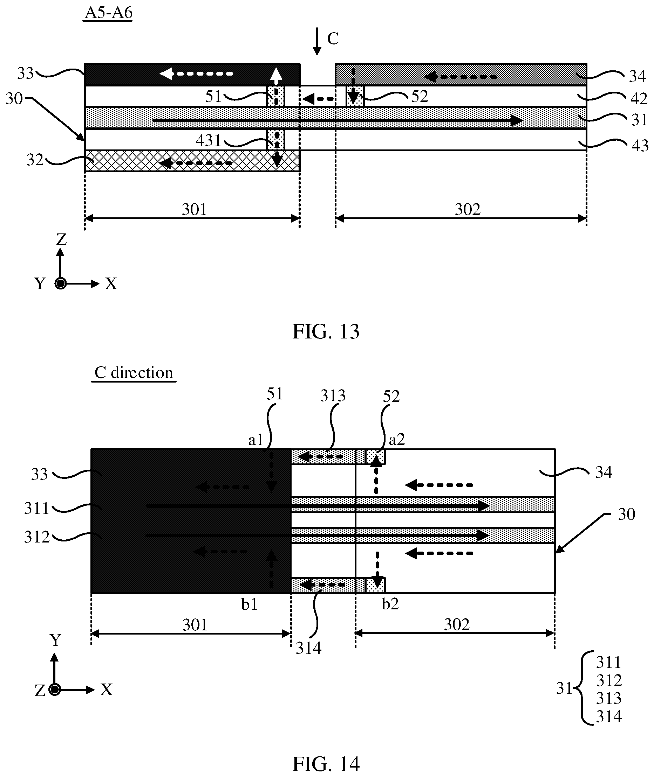

In this case, as shown in FIG. 13 (which is a sectional view obtained by cutting along a dashed line A5-A6 in FIG. 11), the second shielding layer 34 located in the second area 302 may be electrically connected to the second end a2 of the first ground trace 313 (as shown in FIG. 14) in the signal layer 31 through the second electrically conductive adhesive 52. The first end a1 of the first ground trace 313 is electrically connected to the first shielding layer 33 through the first electrically conductive adhesive 51. In this way, the second shielding layer 34 may be electrically connected to the first shielding layer 33 through the first ground trace 313, the first electrically conductive adhesive 51, and the second electrically conductive adhesive 52. In addition, a manner in which the second shielding layer 34 is electrically connected to the first shielding layer 33 through the second ground trace 314 may be obtained similarly, and details are not described herein again.

Based on this, still as shown in FIG. 12, a via (via) 431 is provided on the third dielectric layer 43 located between the signal layer 31 and the reference layer 32. The via 431 may penetrate the third dielectric layer 43, and two ends of the via 431 may be electrically connected to the first end a1 of the first ground trace 313 and the reference layer 32 respectively. In this case, the first ground trace 313 in the signal layer 31 may be electrically connected to the reference layer 32 through the via 431 shown in FIG. 13. Because the first shielding layer 33 is electrically connected to the first ground trace 313, the first shielding layer 33 may be electrically connected to the reference layer 32 through the first ground trace 313 and the via 431. In addition, because the first shielding layer 33 is electrically connected to the second shielding layer 34 through the first ground trace 313, the second shielding layer 34 may be electrically connected to the reference layer 32 through the first shielding layer 33.

In this case, still as shown in FIG. 13, the second shielding layer 34, the second electrically conductive adhesive 52, the first ground trace 313 (as shown in FIG. 14) in the signal layer 31, the first electrically conductive adhesive 51, the first shielding layer 33, the via 431, and the reference layer 32 may form a signal return path. For example, as shown in FIG. 14 (which is a top view obtained in a C direction in FIG. 13), in a case in which the first signal trace 311 and the second signal trace 312 in the signal layer 31 transmit a signal from left to right, for example, the high-speed signal (represented by a solid line arrow in FIG. 13 and FIG. 14), the return signal (represented by a dashed line arrow in FIG. 13 and FIG. 14) of the high-speed signal first passes through the second shielding layer 34 in the second area 302 from right to left.

Next, still as shown in FIG. 13, the return signal from the second shielding layer 34 flows downward to the first ground trace 313 (as shown in FIG. 14) in the signal layer 31 through the second electrically conductive adhesive 52 electrically connected to the second shielding layer 34. The return signal on the first ground trace 313 may flow upward to the first shielding layer 33 located in the first area 301 through the first electrically conductive adhesive 51 shown in FIG. 13. In addition, the return signal on the first ground trace 313 may further flow downward to the reference layer 32 located in the first area 301 through the via 431 shown in FIG. 13.

In conclusion, as shown in FIG. 13, the reference layer 32 is located in the first area 301, and the reference layer 32 is not disposed in the second area 302. Therefore, a quantity of film layers in the second area 302 of the flexible circuit board 30 may be less than a quantity of film layers in the first area 301. In this way, a thickness (a size in the Y direction) of the second area 302 may be less than a thickness of the first area 301. When the flexible circuit board 30 is used in a foldable electronic device, the second area 302 in the flexible circuit board 30 may be used as an area, subject to dynamic flexing, of the flexible circuit board 30, so that the flexible circuit board 30 has good flexing resistance performance.

In addition, as shown in FIG. 14, because the second end a2 that is of the first ground trace 313 in the signal layer 31 and that is located in the second area 302 is electrically connected to the second shielding layer 34, the first end a1 that is of the first ground trace 313 and that is located in the first area 301 is electrically connected to the first shielding layer 33 and the reference layer 32 (as shown in FIG. 13). Therefore, a return signal of a signal transmitted via a signal trace in the signal layer 31 may flow from the second shielding layer 34 located in the second area 302 to the first shielding layer 33 and the reference layer 32 located in the first area 301 through the first ground trace 313, so that return paths of the second area 302 and the first area 301 in the flexible circuit board 30 are continuous. In this way, impedance fluctuation of the flexible circuit board 30 can be reduced, thereby reducing a signal (especially the high-frequency signal) loss caused by the second shielding layer 34 and the first shielding layer 33.

In addition, still as shown in FIG. 14, in a case in which the signal layer 31 further includes the second ground trace 314, similarly, because the second end b2 that is of the second ground trace 314 and that is located in the second area 302 is electrically connected to the second shielding layer 34, the first end b1 that is of the second ground trace 314 and that is located in the first area 301 is electrically connected to the first shielding layer 33 and the reference layer 32 (as shown in FIG. 13). Therefore, a return signal of a signal transmitted via a signal trace in the signal layer 31 may flow from the second shielding layer 34 located in the second area 302 to the first shielding layer 33 and the reference layer 32 located in the first area 301 through the second ground trace 314, so that return paths of the second area 302 and the first area 301 in the flexible circuit board 30 are continuous.

In this case, when the first signal trace 311 and the second signal trace 312 in the signal layer 31 transmit differential signals, a return signal of the first signal trace 311 may flow from the second shielding layer 34 through the first ground trace 313 that is close to the first signal trace 311, and then into the first shielding layer 33 and the reference layer 32. Similarly, a return signal of the second signal trace 312 may flow from the second shielding layer 34 through the second ground trace 314 close to the second signal trace 312, and then into the first shielding layer 33 and the reference layer 32. Because the first ground trace 313 and the second ground trace 314 are spaced by the first signal trace 311 and the second signal trace 312, noise coupling between the first ground trace 313 and the second ground trace 314 can be reduced.

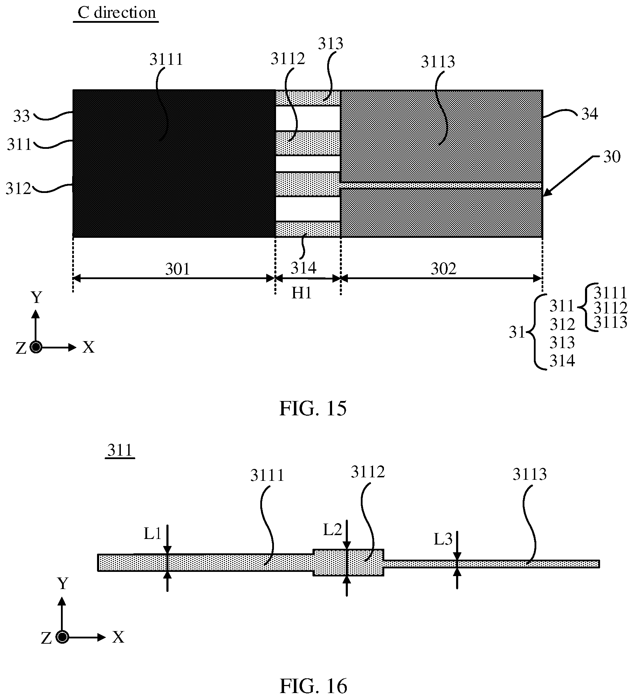

It can be learned from the foregoing descriptions that EMI shielding may be performed on different areas of the flexible circuit board 30 by disposing the first shielding layer 33 and the second shielding layer 34 in different areas of the flexible circuit board 30, for example, the first area 301 and the second area 302, respectively. In addition, because the signal return paths of the first area 301 and the second area 302 are continuous, a signal loss caused by EMI shielding may be reduced. Based on this, to further reduce a signal loss caused by EMI shielding, as shown in FIG. 15 (which is another top view obtained in a C direction in FIG. 13), the first signal trace 311 may include a first part 3111, a second part 3112, and a third part 3113. The first shielding layer 33 covers the first part 3111, the second shielding layer 34 covers the third part 3113, and the second part 3112 is located in the first gap H1.

Based on this, as shown in FIG. 16, the first part 3111 has a first trace width L1, the second part 3112 has a second trace width L2, and the third part 3113 has a third trace width L3. L2>L1 and L2>L3. Because the second part 3112 is located in the first gap H1, no EMI shielding layer is disposed at a position of the second part 3112. A trace width of the second part 3112 is increased to the second trace width L2, to enable the second trace width L2 to be greater than the first trace width L1 of the first part 3111 and the third trace width L3 of the third part 3113, so that the second part 3112 can more easily use the first signal trace 313 on one side of the second part 3112 as a reference ground (GND). In this way, impedance fluctuation of each part in the entire first signal trace 311 can be reduced, thereby achieving an objective of reducing a signal loss caused by EMI shielding.

In addition, in the first signal trace 311, the first part 3111 is covered by the first shielding layer 33 and the reference layer 32 (as shown in FIG. 13), and the first part 3111 may use the first shielding layer 33 and the reference layer 32 as reference grounds, so that the return signal flows through the first shielding layer 33 and the reference layer 32. Similarly, in the first signal trace 311, the third part 3113 is covered by the second shielding layer 34. The third part 3113 may use the second shielding layer 34 as a reference ground, so that the return signal flow through the second shielding layer 34. Based on this, sizes of the first trace width L1 and the third trace width L3 may be determined based on distances (sizes in the Z direction in FIG. 13) between the first part 3111 and each of the first shielding layer 33 and the reference layer 32 and a spacing (a size in the Z direction in FIG. 13) between the third part 3113 and the second shielding layer 34.

For example, when thicknesses of positions of the second dielectric layer 42 in FIG. 13 are consistent, and the thickness of the second shielding layer 34 (a size in the Z direction) is less than the thickness of the first shielding layer 33, the distance between the first part 3111 and the first shielding layer 33 shown in FIG. 15 may be greater than the distance between the third part 3113 and the second shielding layer 34. In this case, the first trace width L1 of the first part 3111 may be greater than the third trace width L3 of the third part 3113, so that the first part 3111 can more easily use the first shielding layer 33 as a reference ground, thereby reducing impedance fluctuation of each part in the entire first signal trace 311, and achieving an objective of reducing a signal loss caused by EMI shielding. For example, the first trace width L1, the second trace width L2, and the third trace width L3 are adjusted, so that an impedance change rate △Z of the first signal trace 311 may satisfy the following range: -10%≤△Z≤+10%. In addition, a manner of disposing the second signal trace 312 in FIG. 15 and a manner of disposing the first signal trace 311 may be obtained in a similar manner, and details are not described herein again.

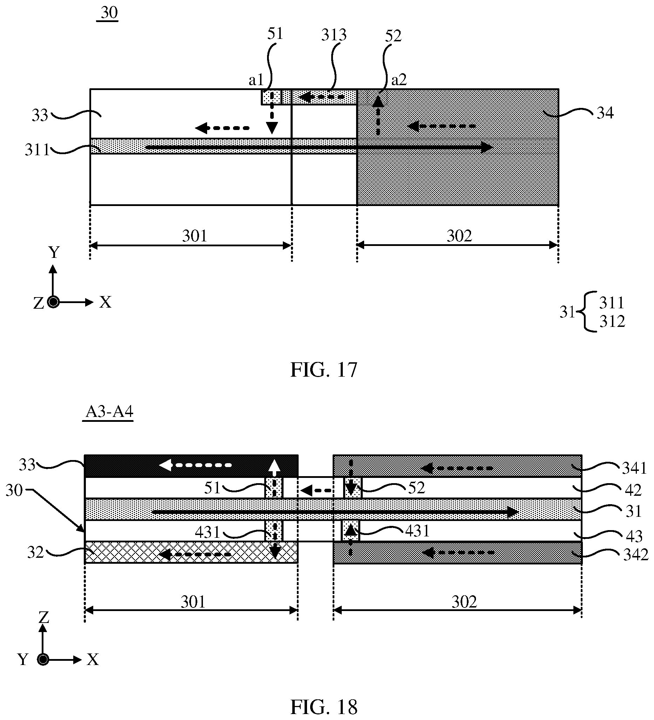

FIG. 14, FIG. 15, and FIG. 16 are described by using an example in which the signal layer 31 includes the first signal trace 311 and the second signal trace 312, and the first ground trace 313 and the second ground trace 314 that are located on two sides of the first signal trace 311 and the second signal trace 312. In some other embodiments of this application, the signal layer 31 may not be configured to transmit differential signals. In this case, one signal channel 300 (as shown in FIG. 7) of the signal layer 31 may include one signal trace, for example, the first signal trace 311 shown in FIG. 17. In this case, the signal layer 31 may further include the first ground trace 313 spaced apart from the first signal trace 311. A manner of electrical connections between the first ground trace 313 and the second shielding layer 34, and between the first shielding layer 33 and the reference layer 32 (as shown in FIG. 13), and a manner of setting a return path of a return signal flowing through the first ground trace 313 are the same as those described above, and details are not described herein again.

In addition, the foregoing descriptions are provided by using an example in which the flexible circuit board 30 has one second shielding layer 34. In some other embodiments of this application, to improve an EMI shielding effect of the second area 302 of the flexible circuit board 30, the flexible circuit board 30 may include two second shielding layers located in the second area 302, which are respectively a second upper shielding layer 341 and a second lower shielding layer 342 shown in FIG. 18 (which is another sectional view obtained by cutting along a dashed line A3-A4 in FIG. 3). The signal layer 31 may be located between the second upper shielding layer 341 and the second lower shielding layer 342.

Similarly, as shown in FIG. 18, the second lower shielding layer 342 may be electrically connected to the ground trace (for example, the first ground trace 313) in the signal layer 31 through the via 431 provided on the third dielectric layer 43, so that a return signal on the second lower shielding layer 342 is returned to the first shielding layer 33 and the reference layer 32 in the first area 301 through the ground trace. In this way, the signal layer 31 is located in a part of the second area 302, and the second upper shielding layer 341 and the second lower shielding layer 342 respectively cover above and below the signal layer 31, thereby improving an EMI shielding effect. In addition, return signals on both the second upper shielding layer 341 and the second lower shielding layer 342 may return to the first shielding layer 33 and the reference layer 32 in the first area 301, so that return paths of the second area 302 and the first area 301 of the flexible circuit board 30 are continuous, to reduce a signal loss caused by EMI shielding, thereby alleviating a problem of a conflict between the EMI shielding and the signal loss.

It can be learned from the foregoing that flexing resistance performance of the second shielding layer (for example, the second upper shielding layer 341 and the second lower shielding layer 342) is higher than flexing resistance performance of the first shielding layer 33. Therefore, when the flexible circuit board 30 is used in a foldable electronic device, the second area 302 that is in the flexible circuit board 30 and that has the second shielding layer (for example, the second upper shielding layer 341 and the second lower shielding layer 342) may be used as an area, subject to dynamic flexing, of the flexible circuit board.

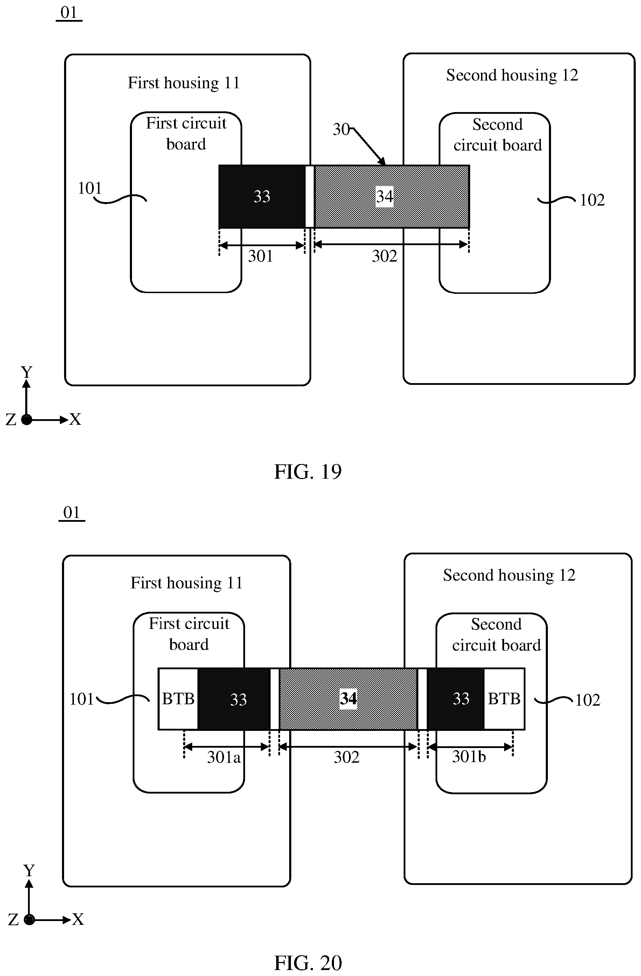

For example, as shown in FIG. 19, the first housing 11 in the electronic device 01 may rotate relative to the second housing 12. In the flexible circuit board 30, the first area 301 in which the first shielding layer 33 is disposed may be fastened to the first circuit board 101 on the first housing 11, and is electrically connected to the first circuit board 101. In addition, in the flexible circuit board 30, the second area 302 in which the second shielding layer 34 is disposed may span the first housing 11 and the second housing 12, so that the second shielding layer 34 may be used as an area, subject to dynamic flexing, of the flexible circuit board, thereby ensuring that the flexible circuit board 30 has good flexing resistance performance in a folding process of the electronic device, and reducing a probability that a function of the flexible circuit board 30 fails. In addition, still as shown in FIG. 19, an end that is of the second area 302 of the flexible circuit board 30 and that faces away from the first area 301 may be fastened to and electrically connected to the second circuit board 102 on the second housing 12. In this way, circuit boards on different housings may be electrically connected through the flexible circuit board 30.

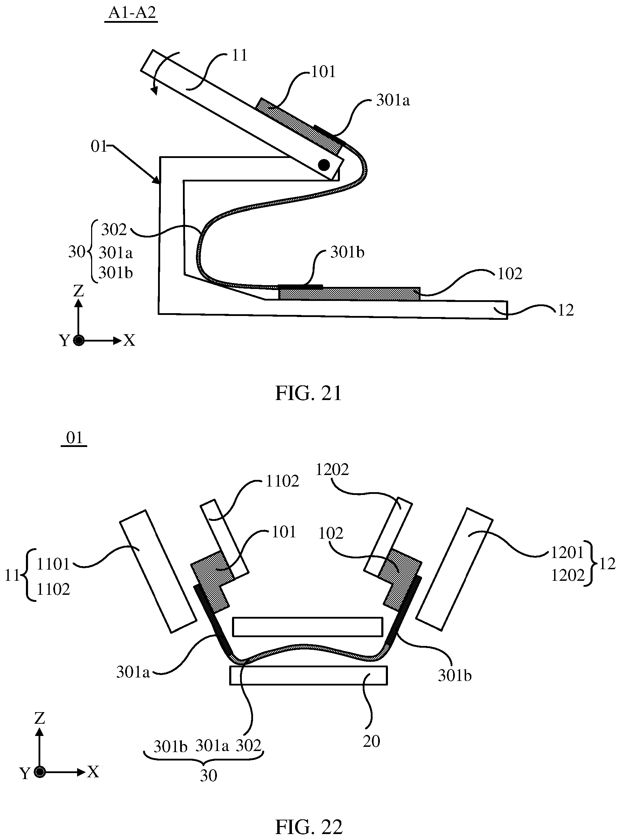

The foregoing descriptions are provided by using an example in which the flexible circuit board 30 has one second area 302 and one first area 301. In some other embodiments of this application, as shown in FIG. 20, the flexible circuit board 30 may include one second area 302 and two first areas. The two first areas may be a first area 301a and a first area 301b respectively. The second area 302 may be located between the first area 301a and the first area 301b. It can be learned from the foregoing that the first circuit board 101 is disposed on the first housing 11, so that the first circuit board 101 may be connected to the first housing 11. In addition, the first circuit board 101 is electrically connected to one (that is, the first area 301a) of the two first areas. For example, the first circuit board 101 may be electrically connected to the first area 301a through a BTB connector, and the first circuit board 101 is connected to the first housing 11. Therefore, a position of the first area 301a and a position of the first housing 11 may be relatively fixed. In addition, the second circuit board 102 is disposed on the second housing 12, so that the second circuit board 102 is connected to the second housing 12. In addition, the second circuit board 102 is electrically connected to the other first area (that is, the first area 301b) of the two first areas. For example, the second circuit board 102 may be electrically connected to the first area 301b through a BTB connector, and the second circuit board 102 is connected to the second housing 12. Therefore, a position of the first area 301b and a position of the second housing 12 may be relatively fixed. In this case, in some embodiments of this application, as shown in FIG. 21 (which is another sectional view obtained by cutting along a dashed line A1-A2 in FIG. 2), because the position of the first area 301a of the flexible circuit board and the position of the first housing 11 are relatively fixed, and the position of the first area 301b of the flexible circuit board and the position of the second housing 12 are relatively fixed, when the first housing 11 is rotatably connected to the second housing 12, the first area 301a and the first area 301b are not subject to dynamic flexing, so that reliability of electrical connections between the flexible circuit board and the first circuit board 101 and between the flexible circuit board and the second circuit board 102 can be ensured.

Alternatively, in some other embodiments of this application, as shown in FIG. 22, the electronic device 01 may further include a hinge mechanism 20. The hinge mechanism 20 may be located between the first housing 11 and the second housing 12, and the first housing 11 and the second housing 12 are rotatably connected to the hinge mechanism 20. In addition, the first circuit board 101 may be electrically connected to the first area 301a. The second circuit board 102 may be electrically connected to the first area 301b.

For example, still as shown in FIG. 22, the first housing 11 may include a first rear housing 1101 and a first middle frame 1102 that are connected. The first circuit board 101 is connected to the first middle frame 1102, so that positions of the first circuit board 101 and the first area 301a and a position of the first housing 11 are relatively fixed. Similarly, the second housing 12 may include a second rear housing 1201 connected to a second middle frame 1202. The second circuit board 102 is connected to the second middle frame 1202, so that positions of the second circuit board 102 and the first area 301b and a position of the second housing 12 are relatively fixed.

In addition, as shown in FIG. 22, either of the first rear housing 1101 and the second rear housing 1201 may be in a rotatable connection or a sliding connection to the hinge mechanism 20, so that the first housing 11 and the second housing 12 are in a rotatable connection to the hinge mechanism 20. A part that is of the flexible circuit board 30 and that is located in the second area 302 may pass through the hinge mechanism 20, so that the second area 302 having the second shielding layer 34 (as shown in FIG. 20) may be located in an area, subject to dynamic flexing, of the flexible circuit board 30.

The foregoing descriptions are provided by using an example in which the flexible circuit board 30 is partitioned, and the flexible circuit board 30 has different EMI shielding layers in different areas, to achieve an objective of EMI shielding. In some other embodiments of this application, on the basis of partitioning of the flexible circuit board 30, EMI shielding may be further performed on a partial area of the flexible circuit board 30 by using another component in the electronic device having the flexible circuit board 30. The following describes the solution in detail by using an example.

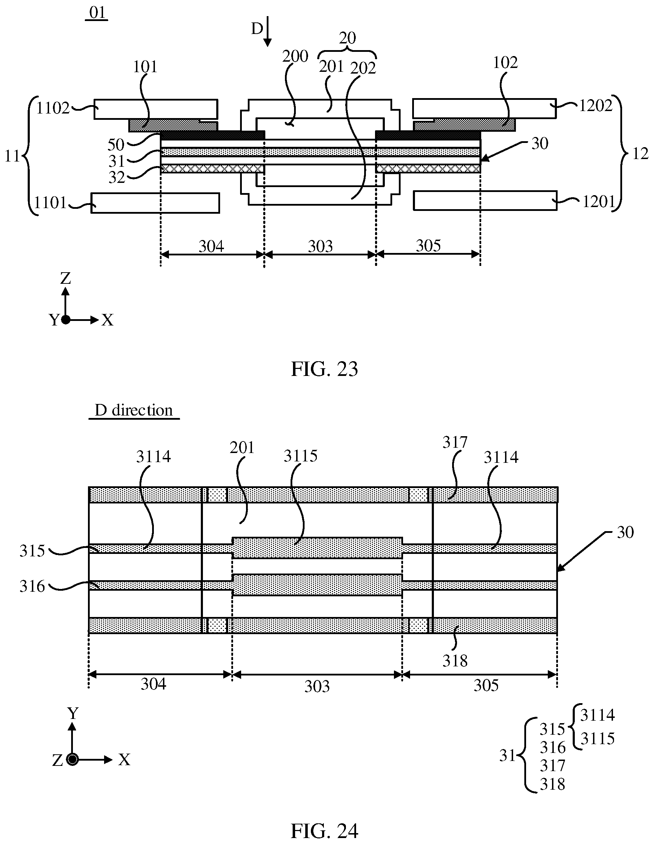

For example, as shown in FIG. 23, the electronic device 01 provided in some embodiments of this application may include a first housing 11, a second housing 12, a first circuit board 101, a second circuit board 102, a hinge mechanism 20, and a flexible circuit board 30. When the first housing 11 includes a first rear housing 1101 and a first middle frame 1102, and the second housing 12 includes a second rear housing 1201 and a second middle frame 1202, a manner in which the first circuit board 101 is connected to the first housing 11 and the second circuit board 102 is connected to the second housing 12 is the same as that described above, and details are not described herein again. In addition, manner in which the first housing 11 and the second housing 12 are connected to the hinge mechanism 20 is the same as that described above, and details are not described herein again.

Based on this, still as shown in FIG. 23, the hinge mechanism 20 may include a first metal hinge cover 201 and a second metal hinge cover 202 that are disposed opposite to each other. An accommodating cavity 200 is formed between the first metal hinge cover 201 and the second metal hinge cover 202. In addition, the flexible circuit board 30 may have a third area 303, a fourth area 304, and a fifth area 305. The third area 303 may be located between the fourth area 304 and the fifth area 305. For example, a part that is of the flexible circuit board 30 and that is located in the fourth area 304 may be electrically connected to the first circuit board 101, and is connected to the first housing 11 through the first circuit board 101 disposed on the first housing 11. A part that is of the flexible circuit board 30 and that is located in the fifth area 305 may be electrically connected to the second circuit board 102, and is connected to the second housing 12 through the second circuit board 102 disposed on the second housing 12.

In addition, still as shown in FIG. 23, the flexible circuit board 30 may include a signal layer 31, a reference layer 32, and a third shielding layer 50. The signal layer 31 may be located in the third area 303, the fourth area 304, and the fifth area 305. The reference layer 32 may be located in the fourth area 304 and the fifth area 305, and the reference layer 32 and the signal layer 31 may be stacked. In addition, the third shielding layer 50 may be located in the fourth area 304 and the fifth area 305, and the third shielding layer 50 may be stacked on a side that is of the signal layer 31 and that faces away from the reference layer 32. A part that is of the flexible circuit board 30 and that is located at least in the third area 303 passes through the accommodating cavity 200, so that the first metal hinge cover 201 or the second metal hinge cover 202 may cover the part that is of the flexible circuit board 30 and that is located at least in the third area 303. In addition, at least one of the first metal hinge cover 201 or the second metal hinge cover 202 may be electrically connected to the reference layer 32.

For example, the third shielding layer 50 may be a metal layer with a high electrical conductivity and a large thickness. In this case, a material and a conductive manner of the third shielding layer 50 are the same as those of the first shielding layer 33. Details are not described herein again. Alternatively, for another example, an electrical conductivity of the third shielding layer 50 is small, for example, the electrical conductivity is less than or equal to 5x10⁷ S/m. Based on this, in some embodiments, the third shielding layer 50 may be a metal foil with a small thickness, or may be a composite structure of a conductive powder or a metal particle and a dielectric material. In this case, a material and a conductive manner of the third shielding layer 50 may be the same as those of the second shielding layer 34. Details are not described herein again. For ease of description, the following uses an example in which the third shielding layer 50 is a metal layer with a large thickness and a high electrical conductivity for description.

In conclusion, still as shown in FIG. 23, the third shielding layer 50 covers both a part that is of the signal layer 31 and that is located in the fourth area 304 and a part that is of the signal layer 31 and that is located in the fifth area 305. The third shielding layer 50 located in the fourth area 304 may perform EMI shielding on a signal trace that is in the signal layer 31 and that is located in the fourth area 304. Similarly, the third shielding layer 50 located in the fifth area 305 may perform EMI shielding on a signal trace that is in the signal layer 31 and that is located in the fifth area 305.

In addition, a part that is of the signal layer 31 and that is located in the third area 303 passes through the accommodating cavity 200 formed between the first metal hinge cover 201 and the second metal hinge cover 202. In addition, at least one of the first metal hinge cover 201 or the second metal hinge cover 202 may be electrically connected to the reference layer 32. Therefore, at least one of the first metal hinge cover 201 or the second metal hinge cover 202 is grounded to the reference layer 32. In this case, a hinge cover that is in the first metal hinge cover 201 or the second metal hinge cover 202 and that is grounded to the reference layer 32 may perform EMI shielding on a signal trace that is in the signal layer 31 and that is located in the third area 303, so that the first metal hinge cover 201 or the second metal hinge cover 202 in the electronic device 01 may be used to perform EMI shielding on the third area 303 of the flexible circuit board 30. In this way, EMI shielding can be implemented in the third area 303, the fourth area 304, and the fifth area 305 in the flexible circuit board 30.

Based on this, still as shown in FIG. 23, because the hinge cover that is in the first metal hinge cover 201 or the second metal hinge cover 202 and that is grounded to the reference layer 32 may perform EMI shielding on the signal trace that is in the signal layer 31 and that is located in the third area 303, the EMI shielding layer does not need to be disposed in the part that is of the flexible circuit board 30 and that is located in the third area 303. In this way, because the first housing 11 and the second housing 12 are rotatably connected to the hinge mechanism 20, the part that is of the flexible circuit board 30 and that is located in the third area 303 may be used as an area, subject to dynamic flexing, of the flexible circuit board 30. In this case, because the EMI shielding layer does not need to be disposed in the part that is of the flexible circuit board 30 and that is located in the third area 303, a thickness (a size in the Z direction) of the flexible circuit board 30 in the third area 303 can be reduced, and flexing resistance of the flexible circuit board 30 in the third area 303 can be improved. In addition, the EMI shielding layer does not need to be disposed in the part that is of the flexible circuit board 30 and that is located in the third area 303, so that a signal loss caused by the EMI shielding can be further reduced, thereby alleviating a problem of a conflict between the EMI shielding and the signal loss.

The foregoing descriptions are based on an example in which the hinge mechanism 20 includes the first metal hinge cover 201 and the second metal hinge cover 202 that are disposed opposite to each other. When both the first metal hinge cover 201 and the second metal hinge cover 202 are electrically connected to the reference layer 32, the grounded first metal hinge cover 201 and the grounded second metal hinge cover 202 respectively cover above and below the third area 303 of the flexible circuit board 30, so that an EMI shielding effect can be improved. Alternatively, in some other embodiments of this application, the hinge mechanism 20 may have only one metal hinge cover of the first metal hinge cover 201 or the second metal hinge cover 202. A grounding manner and a technical effect of the metal hinge cover are the same as those described above, and details are not described herein again. For ease of description, the following uses an example in which the hinge mechanism 20 includes a first metal hinge cover 201 and a second metal hinge cover 202, and at least one of the first metal hinge cover 201 or the second metal hinge cover 202 is electrically connected to the reference layer 32.

It can be learned from the foregoing that, in FIG. 23, at least one of the first metal hinge cover 201 or the second metal hinge cover 202 may be electrically connected to the reference layer 32. The following describes a manner in which the first metal hinge cover 201 or the second metal hinge cover 202 is electrically connected to the reference layer 32 by using an example. In some embodiments of this application, as shown in FIG. 24 (which is a top view obtained in a D direction in FIG. 23), the signal layer 31 of the flexible circuit board 30 may include a third signal trace 315, a fourth signal trace 316, a third ground trace 317, and a fourth ground trace 318. The third signal trace 315 and the fourth signal trace 316 are spaced, and the third signal trace 315 and the fourth signal trace 316 may be located between the third ground trace 317 and the fourth ground trace 318.

In this case, a signal channel formed by the third signal trace 315 and the fourth signal trace 316 may be used to transmit a differential signal. The third ground trace 317 and the fourth ground trace 318 may be electrically connected to the reference layer 32 shown in FIG. 23 through a via provided on the dielectric layer, to implement grounding of the third ground trace 317 and the fourth ground trace 318. A manner of disposing the via on the dielectric layer is the same as that described above, and details are not described herein again. In addition, to improve an EMI shielding effect of the third shielding layer 50, the third ground trace 317 and the fourth ground trace 318 may also be electrically connected to the third shielding layer 50 through an electrically conductive adhesive, so that the third shielding layer 50 is grounded to the reference layer 32 through the third ground trace 317 and the fourth ground trace 318. A disposing manner in which the third shielding layer 50 is electrically connected to the ground trace through the electrically conductive adhesive is the same as that described above, and details are not described herein again.

Based on this, at least one of the first metal hinge cover 201 or the second metal hinge cover 202 may be electrically connected to the third ground trace 317 and the fourth ground trace 318. Because the third ground trace 317 and the fourth ground trace 318 are electrically connected to the reference layer 32 and the third shielding layer 50, in the first metal hinge cover 201 or the second metal hinge cover 202, a hinge cover that is electrically connected to the third ground trace 317 and the fourth ground trace 318 may be electrically connected to the reference layer 32, to implement grounding of the hinge cover.

In some embodiments, when both the first metal hinge cover 201 and the second metal hinge cover 202 shown in FIG. 23 are electrically connected to the reference layer, an upper surface and a bottom surface that are of a part that is of the signal layer 31 and that is located in the third area 303 are respectively covered by the first metal hinge cover 201 and the second metal hinge cover 202, so that an EMI shielding effect can be improved.

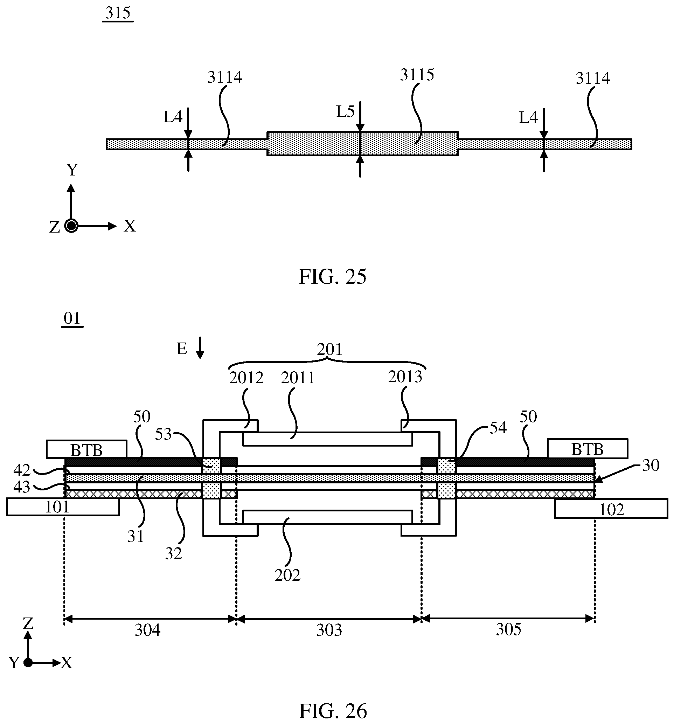

Based on this, as shown in FIG. 24, the third signal trace 315 may include a fourth part 3114 and a fifth part 3115. The fourth part 3114 may be located in the fourth area 304, so that the third shielding layer 50 (as shown in FIG. 23) in the fourth area 304 may cover the fourth part 3114 of the third signal trace 315. In addition, the fifth part 3115 of the third signal trace 315 may pass through the accommodating cavity 200 shown in FIG. 23, that is, the fifth part 3115 may be covered by the first metal hinge cover 201 and the second metal hinge cover 202. In addition, as shown in FIG. 25, the fourth part 3114 may have a fourth trace width L4, and the fifth part 3115 may have a fifth trace width L5, where L5>L4.

It can be learned from the foregoing that the fifth part 3115 of the third signal trace 315 passes through the accommodating cavity 200 shown in FIG. 23, and the EMI shielding layer is not disposed on the part that is of the flexible circuit board 30 and that passes through the accommodating cavity 200. Therefore, a trace width of the fifth part 3115 is increased to the fifth trace width L5, to enable the fifth trace width L5 to be greater than the fourth trace width L4 of the fourth part 3114, so that the fifth part 3115 can more easily use the third signal trace 315 on one side of the fifth part 3115 as a reference ground (GND). In this way, impedance fluctuation of each part in the entire third signal trace 315 can be reduced, thereby achieving an objective of reducing a signal loss caused by EMI shielding. A manner of disposing the fourth signal trace 316 is the same as that described above, and details are not described herein again.

Based on this, to enable the first metal hinge cover 201 to be electrically connected to the third ground trace 317 and the fourth ground trace 318, as shown in FIG. 26, the first metal hinge cover 201 may include a first hinge cover body 2011, a first metal pressing plate 2012, and a second metal pressing plate 2013. The first metal pressing plate 2012 may be located on a side that is of the first hinge cover body 2011 and that faces the first circuit board 101. The first metal pressing plate 2012 is connected to the first hinge cover body 2011, and the first metal pressing plate 2012 is electrically connected to the third ground trace 317 and the fourth ground trace 318 (as shown in FIG. 24). In addition, the second metal pressing plate 2013 is located on a side that is of the first hinge cover body 2011 and that faces the second circuit board 102, the second metal pressing plate 2013 is connected to the first hinge cover body 2011, and the second metal pressing plate 2013 is electrically connected to the third ground trace 317 and the fourth ground trace 318.

The first hinge cover body 2011 may be a metal hinge cover. When the first hinge cover body 2011 is connected to the first metal pressing plate 2012 and the second metal pressing plate 2013 that are located on two sides of the first hinge cover body 2011, the first hinge cover body 2011, the first metal pressing plate 2012, and the second metal pressing plate 2013 may be electrically connected to each other. In this case, when the first metal pressing plate 2012 and the second metal pressing plate 2013 are electrically connected to the third ground trace 317 and the fourth ground trace 318, the entire first metal hinge cover 201 may be electrically connected to the third ground trace 317 and the fourth ground trace 318. In this case, the first metal pressing plate 2012 and the second metal pressing plate 2013 may be separately prepared, and then the first metal pressing plate 2012 and the second metal pressing plate 2013 are assembled with the first hinge cover body 2011, to obtain the first metal hinge cover 201 without changing a preparation process of the first hinge cover body 2011, so that a manufacturing process of the first metal hinge cover 201 can be simplified. In addition, a structure of the second metal hinge cover 202 may be obtained similarly, and details are not described herein again. For example, a cross-sectional shape of the first metal pressing plate 2012 and a cross-sectional shape of the second metal pressing plate 2013 in the Z direction may be an L shape.

Based on this, still as shown in FIG. 26, the electronic device 01 may further include a third electrically conductive adhesive 53 and a fourth electrically conductive adhesive 54. The third electrically conductive adhesive 53 may be located between the first metal pressing plate 2012 and the third ground trace 317 or the fourth ground trace 318 (as shown in FIG. 24) in the signal layer 31. The third electrically conductive adhesive 53 may be connected to the first metal pressing plate 2012 and the third ground trace 317, so that the first metal pressing plate 2012 is electrically connected to the third ground trace 317 (or the fourth ground trace 318) through the third electrically conductive adhesive 53. For example, a via may be provided on a part that is of the flexible circuit board 30 and that is located in the fourth area 304, and a bottom of the via may be exposed and connected to the third ground trace 317 (or the fourth ground trace 318). The third electrically conductive adhesive 53 may be located in the via.

Similarly, the fourth electrically conductive adhesive 54 may be located between the second metal pressing plate 2013 and the third ground trace 317 or the fourth ground trace 318 (as shown in FIG. 24) in the signal layer 31, and the fourth electrically conductive adhesive 54 may be connected to the second metal pressing plate 2013 and the third ground trace 317 (or the fourth ground trace 318). For example, a via may be provided in a part that is of the flexible circuit board 30 and that is located in the fifth area 305, and a bottom of the via may be exposed and connected to the third ground trace 317 (or the fourth ground trace 318). The fourth electrically conductive adhesive 54 may be located in the via.

The foregoing is described by using an example in which the signal layer 31 includes the third signal trace 315, the fourth signal trace 316, the third ground trace 317, and the fourth ground trace 318 shown in FIG. 24. In some other embodiments of this application, the signal layer 31 may not be configured to transmit differential signals. In this case, one signal channel 300 (as shown in FIG. 7) of the signal layer 31 may include one signal trace, for example, the third signal trace 315. In this case, the signal layer 31 may further include a third ground trace 317 spaced apart from the third signal trace 315. A manner of electrically connecting the third ground trace 317 and at least one of the first metal hinge cover 201 and the second metal hinge cover 202 is the same as that described above, and details are not described herein again.

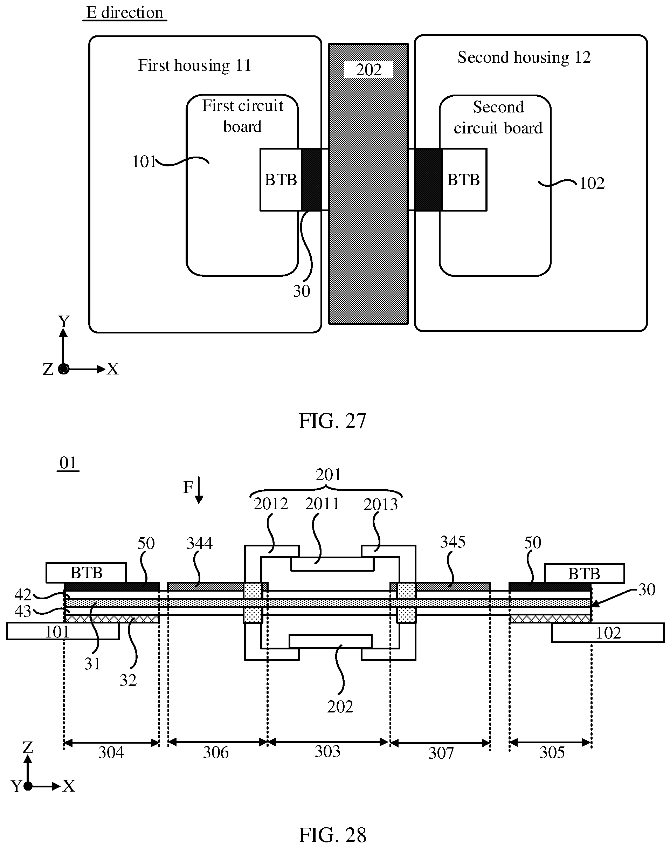

In addition, FIG. 26 is described by using an example in which two sides of the third area 303 that is used as a dynamic flexing area in the flexible circuit board 30 are adjacent to the fourth area 304 and the fifth area 305 that are used as non-flexing areas. For example, a side on which the third shielding layer 50 is located faces the BTB, and a side on which the reference layer 32 is located faces the first circuit board 101 or the second circuit board 102. In this case, as shown in FIG. 27 (which is a sectional view obtained in an E direction in FIG. 26), a part that is of the flexible circuit board 30 and that extends out of the first metal hinge cover 201 is electrically connected to the BTB, and a distance (a size in the X direction) between the BTB and the first metal hinge cover 201 is short. Therefore, the dynamic flexing area of the flexible circuit board 30 is basically located in an area covered by the first metal hinge cover 201 (that is, the third area 303 shown in FIG. 26).

FIG. 26 illustrates an example in which a side on which the third shielding layer 50 is located faces the BTB, and a side on which the reference layer 32 is located faces the first circuit board 101 or the second circuit board 102. Alternatively, for another example, a side on which the third shielding layer 50 is located may face the first circuit board 101 or the second circuit board 102, and a side on which the reference layer 32 is located faces the BTB.

In some other embodiments of this application, as shown in FIG. 28, the flexible circuit board 30 may further have a sixth area 306 and a seventh area 307. The sixth area 306 may be located between the third area 303 and the fourth area 304, and the seventh area 307 may be located between the third area 303 and the fifth area 305.

In this case, to improve flexing resistance performance of the flexible circuit board 30, as shown in FIG. 28, the signal layer 31 may be further located in the sixth area 306 and the seventh area 307. In addition, the flexible circuit board 30 may further include a fourth shielding layer 344 and a fifth shielding layer 345. The fourth shielding layer 344 may be located in the sixth area 306, and the fourth shielding layer 344 may be stacked with the signal layer 31. The fifth shielding layer 345 is located in the seventh area 307, and the fifth shielding layer 345 and the signal layer 31 are stacked. An electrical conductivity of the third shielding layer 50 may be greater than that of at least one of the fourth shielding layer 344 or the fifth shielding layer 345. The at least one of the fourth shielding layer 344 or the fifth shielding layer 345 may be a metal foil with a small thickness, or may be a composite structure of a conductive powder or a metal particle and a dielectric material. In this case, the at least one of the fourth shielding layer 344 or the fifth shielding layer 345 may be the same as a material and a conductive manner of the second shielding layer 34. Details are not described herein again.

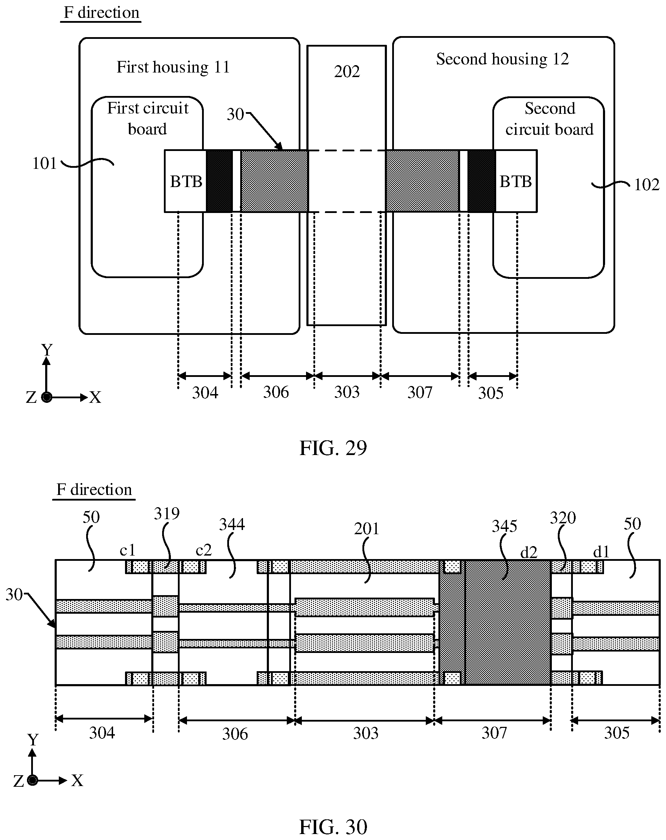

Shielding effects of the fourth shielding layer 344 and the fifth shielding layer 345 are the same as those described above, and details are not described herein again. In addition, compared with the third shielding layer 50, the fourth shielding layer 344 and the fifth shielding layer 345 have better flexing resistance. In this case, as shown in FIG. 29 (which is a top view obtained in an F direction in FIG. 28), when the distance between the BTB and the first metal hinge cover 201 is long, parts that are of the flexible circuit board 30 and that are located in the sixth area 306 and the seventh area 307 and a part covered by the first metal hinge cover 201 may be used as dynamic flexing areas, so that flexing resistance performance of the entire flexible circuit board 30 can be improved.

In some other embodiments, in the sixth area 306, another shielding layer that is located in the signal layer 31 and that faces away from the fourth shielding layer 344 may be further disposed, and a material and a conductive manner of the shielding layer may be the same as those of the fourth shielding layer 344. Similarly, in the seventh area 307, another shielding layer that is located in the signal layer 31 and that faces away from the fifth shielding layer 345 may be further disposed, and a material and a conductive manner of the shielding layer may be the same as those of the fifth shielding layer 345.

Based on this, to reduce a signal loss caused by an EMI shielding effect of the fourth shielding layer 344 and the fifth shielding layer 345, as shown in FIG. 30 (which is another top view obtained in an F direction in FIG. 28), the signal layer 31 may further include a fifth ground trace 319 and a sixth ground trace 320. A first end c1 of the fifth ground trace 319 is located in the fourth area 304, and the first end c1 of the fifth ground trace 319 may be electrically connected to the third shielding layer 50 and the reference layer 32 (as shown in FIG. 28) in the fourth area 304. A second end c2 of the fifth ground trace 319 is located in the sixth area 306, and the second end c2 of the fifth ground trace 319 may be electrically connected to the fourth shielding layer 344. A manner of electrically connecting the third shielding layer 50, the reference layer 32, and the fourth shielding layer 344 through the fifth ground trace 319 and a technical effect of reducing a signal loss of the flexible circuit board 30 are the same as those described above. Details are not described herein again.

In addition, a first end d1 of the sixth ground trace 320 is located in the fifth area 305, and the first end d1 of the sixth ground trace 320 may be electrically connected to the third shielding layer 50 and the reference layer 32 (as shown in FIG. 28) in the fifth area 305. A second end d2 of the sixth ground trace 320 is located in the seventh area 307, and the second end d2 of the sixth ground trace 320 may be electrically connected to the fifth shielding layer 345. A manner of electrically connecting the third shielding layer 50, the reference layer 32, and the fifth shielding layer 345 through the sixth ground trace 320 and a technical effect of reducing a signal loss of the flexible circuit board 30 are the same as those described above. Details are not described herein again.

The foregoing descriptions are provided by using an example in which the third shielding layer 50 in FIG. 27 or FIG. 28 is a metal layer with a large thickness and a high electrical conductivity. In some other embodiments of this application, in FIG. 27 or FIG. 28, the third shielding layer 50 may be a metal foil with a low electrical conductivity and a small thickness, or the third shielding layer 50 may be a composite structure of a conductive powder or a metal particle and a dielectric material. Based on this, because a metal layer with a large thickness does not need to be disposed in the flexible circuit board 30 as a shielding layer, the flexible circuit board 30 may have good flexing resistance performance.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A flexible circuit board, wherein the flexible circuit board has a first area and a second area, and the flexible circuit board comprises:
a signal layer, located in the first area and the second area, wherein the signal layer comprises a first ground trace;
a reference layer, located in the first area, and stacked with the signal layer;
a first shielding layer, located in the first area, and stacked on a side that is of the signal layer and that faces away from the reference layer; and
a second shielding layer, located in the second area, and stacked with the signal layer, wherein
a first end of the first ground trace is located in the first area, and is electrically connected to the first shielding layer and the reference layer; and a second end of the first ground trace is located in the second area, and is electrically connected to the second shielding layer.

2. The flexible circuit board according to claim 1, wherein the flexible circuit board further comprises:
a second dielectric layer, located between the first shielding layer and the signal layer, wherein the second dielectric layer is further located between the second shielding layer and the signal layer; a first hole and a second hole are provided on the second dielectric layer; and the first hole exposes the first end of the first ground trace, and the second hole exposes the second end of the first ground trace;
a first electrically conductive adhesive, located in the first hole, wherein the first electrically conductive adhesive is connected to the first end of the first ground trace and the first shielding layer; and
a second electrically conductive adhesive, located in the second hole, wherein the second electrically conductive adhesive is connected to the second end of the first ground trace and the second shielding layer.

3. The flexible circuit board according to claim 2, wherein the flexible circuit board further comprises:
a third dielectric layer, located between the signal layer and the reference layer; and
a via, penetrating the third dielectric layer, wherein two ends of the via are electrically connected to the first end of the first ground trace and the reference layer respectively.

4. The flexible circuit board according to any one of claims 1 to 3, wherein the flexible circuit board comprises two second shielding layers: a second upper shielding layer and a second lower shielding layer, and the signal layer is located between the second upper shielding layer and the second lower shielding layer.

5. The flexible circuit board according to any one of claims 1 to 4, wherein a first gap H1 exists between the first shielding layer and the second shielding layer, and 0.2 mm≤H1≤6 mm.

6. The flexible circuit board according to claim 5, wherein the signal layer further comprises:
a first signal trace;
a second signal trace, spaced apart from the first signal trace; and
a second ground trace, wherein the first signal trace and the second signal trace are located between the first ground trace and the second ground trace, a first end of the second ground trace is located in the first area and is electrically connected to the first shielding layer and the reference layer, and a second end of the second ground trace is located in the second area and is electrically connected to the second shielding layer.

7. The flexible circuit board according to claim 6, wherein
the first signal trace comprises a first part, a second part, and a third part, the first shielding layer covers the first part, the second shielding layer covers the third part, and the second part is located in the first gap H1; and
the first part has a first trace width L1, the second part has a second trace width L2, and the third part has a third trace width L3, wherein L2>L1, and L2>L3.

8. The flexible circuit board according to any one of claims 1 to 7, wherein an electrical conductivity of the first shielding layer is greater than an electrical conductivity of the second shielding layer.

9. The flexible circuit board according to claim 8, wherein
both the first shielding layer and the second shielding layer are metal layers, and a thickness of the first shielding layer is greater than a thickness of the second shielding layer.

10. The flexible circuit board according to claim 8, wherein
the first shielding layer is a metal layer; and
the second shielding layer is a dielectric layer doped with a metal particle.

11. An electronic device, comprising:
a circuit board; and
the flexible circuit board according to any one of claims 1 to 10, wherein the flexible circuit board is electrically connected to the circuit board.

12. The electronic device according to claim 11, wherein
the flexible circuit board comprises two first areas, a second area of the flexible circuit board is located between the two first areas, the electronic device comprises two circuit boards: a first circuit board and a second circuit board, and the electronic device further comprises a first housing and a second housing that are rotatably connected;
the first circuit board is disposed on the first housing, and the first circuit board is electrically connected to one of the two first areas; and
the second circuit board is disposed on the second housing, and the second circuit board is electrically connected to the other of the two first areas.

13. The electronic device according to claim 12, wherein the electronic device further comprises:
a hinge mechanism, located between the first housing and the second housing, wherein the first housing and the second housing are rotatably connected to the hinge mechanism; and a part that is of the flexible circuit board that is located in the second area passes through the hinge mechanism.

14. An electronic device, comprising:
a first housing;
a second housing;
a first circuit board, connected to the first housing;
a second circuit board, connected to the second housing;
a hinge mechanism, located between the first housing and the second housing, wherein the first housing and the second housing are rotatably connected to the hinge mechanism, and the hinge mechanism comprises a first metal hinge cover; and
a flexible circuit board, comprising a third area, a fourth area, and a fifth area, wherein the third area is located between the fourth area and the fifth area, the fourth area is connected to the first housing, and the fifth area is connected to the second housing; the flexible circuit board comprises a signal layer, a reference layer, and a third shielding layer; the signal layer is located in the third area, the fourth area, and the fifth area; the reference layer is located in the fourth area and the fifth area, and is stacked with the signal layer; and the third shielding layer is located in the fourth area and the fifth area, and is stacked on a side that is of the signal layer and that faces away from the reference layer, wherein
the first circuit board is electrically connected to the fourth area, the second circuit board is electrically connected to the fifth area, the first metal hinge cover covers a part that is of the flexible circuit board and that is located at least in the third area, and the first metal hinge cover is electrically connected to the reference layer.

15. The electronic device according to claim 14, wherein
the signal layer further comprises a third signal trace, the third signal trace comprises a fourth part and a fifth part, the third shielding layer covers the fourth part, and the first metal hinge cover covers the fifth part; and
the fourth part has a fourth trace width L4, and the fifth part has a fifth trace width L5, wherein L5>L4.

16. The electronic device according to claim 15, wherein
the third ground trace is electrically connected to the reference layer and the third shielding layer; and
the first metal hinge cover is further electrically connected to the third ground trace.

17. The electronic device according to claim 16, wherein the first metal hinge cover comprises:
a first hinge cover body;
a first metal pressing plate, located on a side that is of the first hinge cover body and that faces the first circuit board, wherein the first metal pressing plate is connected to the first hinge cover body, and is electrically connected to the third ground trace; and
a second metal pressing plate, located on a side that is of the first hinge cover body and that faces the second circuit board, wherein the second metal pressing plate is connected to the first hinge cover body, and is electrically connected to the third ground trace.

18. The electronic device according to claim 17, wherein the electronic device further comprises:
a third electrically conductive adhesive, located between the first metal pressing plate and the third ground trace, wherein the third electrically conductive adhesive is connected to the first metal pressing plate and the third ground trace; and
a fourth electrically conductive adhesive, located between the second metal pressing plate and the third ground trace, wherein the fourth electrically conductive adhesive is connected to the second metal pressing plate and the third ground trace.

19. The electronic device according to any one of claims 15 to 18, wherein
the signal layer further comprises a fourth signal trace and a fourth ground trace, the third signal trace and the fourth signal trace are spaced, and the third signal trace and the fourth signal trace are located between the third ground trace and the fourth ground trace; and
the fourth ground trace is electrically connected to the reference layer and the third shielding layer, and the first metal hinge cover is further electrically connected to the fourth ground trace.

20. The electronic device according to any one of claims 14 to 19, wherein the flexible circuit board further has a sixth area and a seventh area, the sixth area is located between the third area and the fourth area, the seventh area is located between the third area and the fifth area, and the signal layer is further located between the sixth area and the seventh area;
the flexible circuit board further comprises:
a fourth shielding layer, located in the sixth area, and stacked with the signal layer; and
a fifth shielding layer, located in the seventh area, and stacked with the signal layer; and
the signal layer comprises:
a fifth ground trace, wherein a first end of the fifth ground trace is located in the fourth area, and is electrically connected to the third shielding layer and the reference layer in the fourth area; and a second end of the fifth ground trace is located in the sixth area, and is electrically connected to the fourth shielding layer; and
a sixth ground trace, wherein a first end of the sixth ground trace is located in the fifth area, and is electrically connected to the third shielding layer and the reference layer in the fifth area; and a second end of the sixth ground trace is located in the seventh area, and is electrically connected to the fifth shielding layer.

21. The electronic device according to any one of claims 14 to 20, wherein
the hinge mechanism further comprises a second metal hinge cover, the second metal hinge cover is disposed opposite to the first metal hinge cover, and the second metal hinge cover is electrically connected to the reference layer.
